# FASCICULE DE BREVET EUROPEEN

(11) **EP 3 109 202 B1**
(45) Date de publication et mention de la délivrance du brevet: **26.05.2021**
(21) Numéro de dépôt: 15173721.0
(22) Date de dépôt: 24.06.2015
(51) Int. Cl.: C01B 32/16, B60C 1/00, C08F 279/00, C01B 32/162

(54) **ELÉMENT COMPOSITE COMPRENANT UN MATÉRIAU BIPHASIQUE À BASE DE SILICE ET DE NANOTUBES DE CARBONE**
VERBUNDELEMENT, DAS EIN BIPHASENMATERIAL AUF BAIS VON SILICIUMDIOXID UND KOHLENSTOFFNANORÖHREN UMFASST
COMPOSITE ELEMENT COMPRISING A SILICA- AND CARBON NANOTUBE-BASED BIPHASIC MATERIAL

(43) Date de publication de la demande: 28.12.2016
(73) Titulaire: Luxembourg Institute of Science and Technology (LIST), 4362 Esch-sur-Alzette (LU)
(72) Inventeur: Didier ARL, F-57050 METZ (FR); Damien LENOBLE, B-6920 WELLIN (BE); Mouhamadou Moustapha SARR, F-67000 STRASBOURG (FR)
(74) Mandataire: Lecomte & Partners

(56) Documents cités:
- WANG HONG ET AL: "Catalysts for chirality selective synthesis of single-walled carbon nanotubes", CARBON, ELSEVIER, OXFORD, GB, vol. 81, 28 septembre 2014 (2014-09-28), pages 1-19, XP029093003, ISSN: 0008-6223, DOI: 10.1016/J.CARBON.2014.09.063
- WEI-DE ZHANG ET AL: "Polymer Nanocomposites Using Urchin-Shaped Carbon Nanotube-Silica Hybrids as Reinforcing Fillers", MACROMOLECULAR RAPID COMMUNICATIONS, vol. 25, no. 21, 3 novembre 2004 (2004-11-03), pages 1860-1864, XP055232043, DE ISSN: 1022-1336, DOI: 10.1002/marc.200400352
- Li Chunhua: "SCIENCE IN CHINA (Series E) Synthesis of carbon nanotubes with Ni/CNTs catalyst", XU Cailu () & WU Dehai (3ǷǷ), 30 juin 2003 (2003-06-30), XP055231947, Extrait de l'Internet: URL:http://tech.scichina.com:8082/sciEe/fi leup/PDF/03ye0303.pdf [extrait le 2015-11-27]
- SOLANKI R ET AL: "Atomic layer deposition of copper seed layers", ELECTROCHEMICAL AND SOLID-STATE LETTERS, IEEE SERVICE CENTER, PISCATAWAY, NJ, US, vol. 3, no. 10, 1 octobre 2000 (2000-10-01), pages 479-480, XP002254875, ISSN: 1099-0062, DOI: 10.1149/1.1391185

## Description

### Domaine technique

L'invention a trait à un élément composite comprenant un agent de renforcement basé sur un matériau biphasique à base de silice, en particulier à base de diatomée, et de nanotubes de carbone. Plus particulièrement, l'invention a trait à un matériau composite avec une matrice de polymère comprenant une charge inorganique composée d'un matériau biphasé avec un substrat mésoporeux de porosité non-organisée comprenant de la silice de diatomées, le substrat mésoporeux étant recouvert au moins partiellement de nanotubes de carbone.

### Art antérieur

Les diatomées sont des organismes aquatiques microscopiques et unicellulaires disposant d'une enveloppe siliceuse (d'épaisseur 50 nm). De formes et de tailles différentes variant entre 1 et 10 microns, la silice de diatomées est constituée de nano-pores, de nano-canaux auto-organisés, ce qui lui confère une grande surface spécifique de l'ordre de 3 à 200 m²/g. Cette grande surface spécifique offre la possibilité d'y faire croître une grande densité de CNTs en plus d'avoir une grande surface de contact avec la matrice.

Les diatomites sont définies comme une roche siliceuse d'origine organique.

La fabrication d'un matériau biphasé CNTs/silice de diatomées est un défi technologique à relever dans la mesure où les diatomées sont des structures de formes complexes et que la croissance de nanotubes de carbone nécessite plusieurs étapes selon la méthode de croissance choisie.

Il est supposé que l'utilisation de CNTs en remplacement du noir de carbone (carbone amorphe) dans les matériaux composites favorisera l'émergence de nouveaux matériaux avec toutes sortes de nouvelles propriétés intéressantes.

En effet, les CNTs sont connus pour posséder de meilleures propriétés par rapport au noir de carbone. L'amélioration de la résistance à l'usure et/ou la meilleure rétention de propriétés mécaniques peuvent entre autres être citées.

Les méthodes de dépôts chimiques en phase vapeur permettent de déposer des films ou des nanoparticules sur des substrats à partir de précurseurs injectés au proche du substrat en phase gazeuse. Le principe consiste à mettre sous forme gazeuse les précurseurs qui peuvent être liquides, solides ou gazeux et à les faire réagir entre eux pour former un film ou des nanostructures solides sur le substrat. L'avantage des méthodes en phase gazeuse par rapport aux méthodes en phase liquide est de pouvoir considérer tout type de substrats, y compris les substrats présentant une morphologie complexe comme les diatomées.

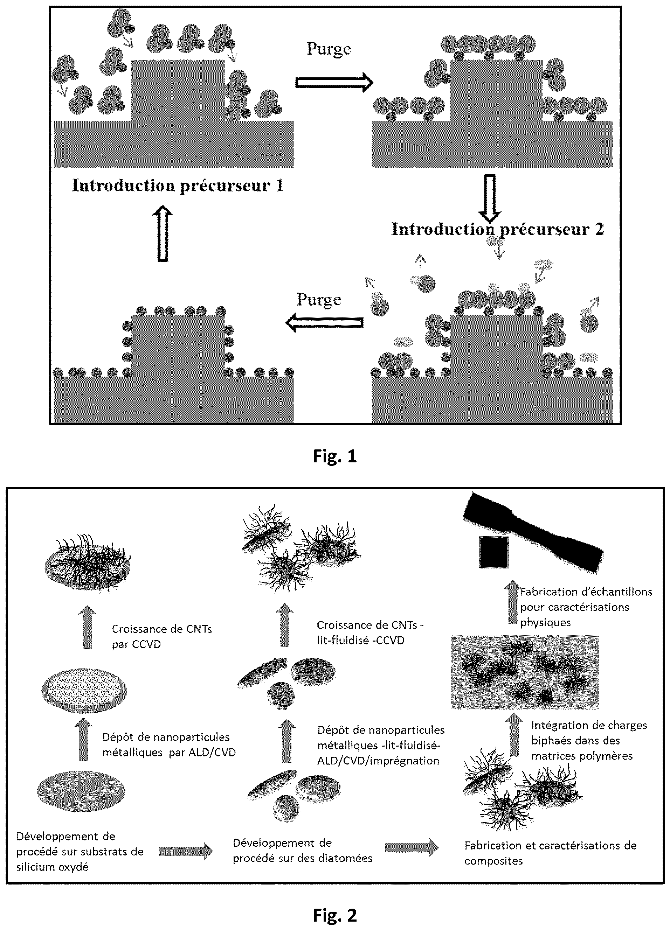

Les dépôts de couche atomique (ALD) (voir figure 1) consistent à faire réagir alternativement les précurseurs à la surfaces des substrats et présentent l'avantage d'être la technique qui aboutit aux plus grand taux de couverture (He M., et al., Nano Res., 2010, 4, 334-342).

Le principe de l'ALD consiste à injecter alternativement deux précurseurs séparés par un gaz de purge. Les précurseurs peuvent être solides, liquides ou gazeux mais ils seront transformés en vapeur avant d'être envoyés dans la chambre de réaction. Les étapes du procédé d'un cycle ALD sont décrites comme suit :
a. Introduction du précurseur 1 : quelle que soit sa nature (solide, liquide ou gazeuse), celui-ci doit être vaporisée depuis son contenant et transportée par un gaz vecteur inerte jusqu'à la chambre de réaction. Ce précurseur s'adsorbe sur la surface du substrat. La durée d'exposition du précurseur est un paramètre influant la structure du film puisqu'il permet de moduler la saturation de la surface par les molécules des précurseurs.
b. Purge : après l'adsorption du précurseur 1 sur le substrat, on introduit un gaz inerte pour purger et évacuer vers la pompe les molécules qui n'ont pas pu s'adsorber à la surface.
c. Introduction du précurseur 2 : la vapeur du précurseur 2 (ou réactant) est introduite dans la chambre et cette dernière est destinée à réagir avec les molécules du précurseur 1 déjà adsorbées. Le produit de la réaction forme la première couche atomique du film. Ce type de précurseur est souvent un agent réducteur, un agent oxydant, un agent nitrosant, un agent capable d'enlever un ligand du précurseur 1 ou d'apporter un élément manquant.
d. Seconde purge : une autre purge est faite dans la chambre pour évacuer tous les sous-produits de la réaction entre les deux précurseurs.

La température, la pression, et le nombre de cycles influencent également la technique ALD.

Une seconde méthode qui est utilisée pour faire croître les nanotubes de carbones est la méthode dite de dépôt chimique en phase vapeur (« CVD » en anglais). Le substrat est exposé à un ou plusieurs précurseurs en phase gazeuse, qui réagissent et/ou se décomposent à la surface du substrat pour générer le dépôt désiré.

Une troisième méthode qui peut être envisagée est la méthode de l'imprégnation en phase vapeur, qui consiste à saturer la surface du substrat par les molécules destinée à être greffée. Cette méthode est en réalité une variante de la CVD qui est utilisée lorsque le substrat devant être fonctionnalisé présente un caractère fibreux.

Il a été rapporté (Duraia E. M., et al., Vacuum, 2010, 84, 464-468) la formation de nanotubes de carbone (CNT) verticaux utilisant comme substrat la diatomite, combinant donc les avantages des CNT (propriétés électriques et optiques) et ceux de la diatomite (matériau naturel pas cher et utile dans la purification de l'eau) dans un seul matériau. La technique de dépôt chimique en phase vapeur assisté par plasma à micro-ondes a été utilisée pour la croissance des CNTs sur la diatomite. Une étape de prétraitement a été nécessaire avant l'étape de croissance des CNTs dont le méthane (CH₄) est la source principale de carbone.

Par ailleurs, il a été rapporté (Zhao J., et al., Composites : Part A, 2014, 58; 1-6) que des matériaux composites (synthétisés par le procédé sol-gel) à base de polyuréthane et renforcés par de la silice et des CNTs à multi-parois permettent d'augmenter la conductivité thermique du matériau de base, à savoir le polyuréthane. L'incorporation de la silice dans la matrice de polymère permet de maintenir la résistivité électrique du polyuréthane.

Il a également été rapporté (Zhang W.D., et al., Macromol. Rapid Commun., 2004, 25, 1860-1864) que des nanocomposites à base de nylon-6 renforcées par des CNTs et des particules mésoporeuses de silice de type MCM-41 permettent d'améliorer le module de Young et la solidité du matériau.

### Résumé de l'invention

### Problème technique

L'invention a comme problème technique de développer des matériaux composites à base d'une matrice de polymère et d'un agent de renforcement présentant à la fois une surface spécifique très importante et des propriétés intrinsèques au nanotubes de carbones qui sont meilleures que les propriétés du noir de carbone.

De manière générale, la stabilité des matériaux composites, par l'amélioration de l'interfaçage entre la matrice de polymère et l'agent de renforcement, sera augmentées. L'utilisation des nanotubes de carbone résout le problème d'apporter notamment des propriétés thermiques, électriques et/ou mécaniques dans de tels matériaux composites.

### Solution technique

L'invention a pour objet un matériau composite selon les revendications 1 à 8 et un procédé de synthèse dudit matériau composite selon les revendications 9 à 29.

### Avantages de l'invention

L'invention est particulièrement intéressante en ce que le matériau composite selon la présente invention comporte des propriétés thermiques, électriques et mécaniques intéressantes. Les matériaux composites sont en effet plus stables thermiquement et présente un taux de conductivité important. Au niveau des propriétés mécaniques, il faut remarquer l'augmentation du module de Young, ainsi que les valeurs des paramètres de contrainte et de déformation à la rupture des matériaux composite selon l'invention. L'importante surface spécifique des diatomées permet un accrochage stable à la matrice polymérique ainsi qu'une fonctionnalisation élevée (par les CNTs) de ce type de substrats mésoporeux.

### Brèves description des dessins

Figure 1 : Principe de l'ALD.
Figure 2 : Fabrication de composite renforcés par un matériau biphasé (diatomées + CNTs).
Figure 3 : Taux de croissance par cycle en fonction de t_{alcool} et du type d'alcool à 250°C avec tNi =t_{P} =2s.
Figure 4 : Profiles en profondeur XPS de films déposés en utilisant le Ni(acac)₂ et (a) propanol, (b) éthanol et (c) méthanol comme agents de réduction.
Figure 5 : Spectres XPS des niveaux de cœur de Ni 2p et C 1s des films déposés en utilisant différents alcools comme agents de réduction à 300°C et 400 s de temps de décapage.
Figure 6 : Profils en profondeur XPS de films déposés à 350°C en utilisant le Co(acac)₂ réduit par les trois alcools, le temps de pulse de Co(acac)₂ est de 3s, le temps de purge 2s, le temps de pulse des alcools, 4s et 4000 cycles.
Figure 7 : Spectres XPS des niveaux de cœur a) à la surface et à 300s de pulvérisation à l'argon du C 1s, b) du C 1s et sa déconvolution par une fonction Gaussien-Lorentzien, c) du Co 2p à la surface et à 300s de pulvérisation à l'argon des films déposés à 350°C réduits par le propanol.
Figure 8 : Procédure de croissance de nanotubes sur substrat plan.
Figure 9 : Images MEB de la morphologie des différents substrats utilisés pour la croissance de nanotubes de carbone.
Figure 10 : Images MEB des structures carbonées synthétisées à 500°C et 700°C sur des catalyseurs réalisés par ALD de Ni(acac)₂ et de méthanol à 300°C, 1000 cycles et 3000 cycles.
Figure 11 : Images MEB de la morphologie des films déposés dans différentes conditions utilisés pour la croissance de nanotubes de carbone.
Figure 12 : Images MET de l'échantillon synthétisé à 500°C sur des catalyseurs réalisés par CVD.
Figure 13 : Images MET de l'échantillon synthétisé à 700°C sur des catalyseurs réalisés par CVD.
Figure 14 : Images MEB de nanotubes de carbone synthétisés à différentes températures après imprégnation en phase vapeur.
Figure 15 : Images MET de l'échantillon synthétisé à 700°C sur des catalyseurs réalisés par imprégnation.
Figure 16 : Images MEB des structures carbonées synthétisées à 500°C et 700°C sur des catalyseurs réalisés par ALD.
Figure 17 : Images MET des structures carbonées synthétisées à 500°C et 700°C sur des catalyseurs réalisés par ALD.
Figure 18 : Images MEB de nanotubes de carbone synthétisés sur des échantillons réalisés par ALD Co, 300°C, 1000 cycles et 4000 cycles.
Figure 19 : Images MEB de nanotubes de carbone synthétisés à différents temps de croissance.
Figure 20 : Images MEB de nanotubes de carbone synthétisés à différents temps de réduction.
Figure 21 : Images MEB de nanotubes de carbones synthétisés à différentes concentration d'acétylène.
Figure 22 : Images MEB de la morphologie des dépôts de nanoparticules de carbure de cobalt en fonction de la température du procédé ALD.
Figure 23 : morphologie des dépôts et distribution en taille des grains de cobalt en fonction du nombre de cycles de dépôt ALD.
Figure 24 : Images MET de nanotubes sur diatomées synthétisés à différentes températures.
Figure 25 : Images MET de nanotubes sur diatomées synthétisés à différents temps de croissance.
Figure 26 : Images MET de nanotubes sur diatomées synthétisés à différentes concentrations d'acétylène.
Figure 27 : Images MET de nanotubes sur diatomées synthétisés à différents temps de réduction.
Figure 28 : Images MEB de nanotubes sur diatomées synthétisés à 600°C, 45 minutes, 20% de concentration en acétylène et 20 minutes de réduction à l'hydrogène.
Figure 29 : Analyses thermogravimétriques sous air de nanotubes sur diatomées synthétisés à 600°C, 45 minutes, 20% de concentration acétylène et 20 minutes de réduction.
Figure 30 : Images MET de composite à base de PMMA et de matériaux biphasés (10%) mélangés à 10 rpm.
Figure 31 : Dégradation thermique du PMMA.
Figure 32 : Dégradation thermique du PMMA et du PMMA renforcé par des diatomées en charge massique croissante, le tout mélangé à 10 rpm.
Figure 33 : Dégradation thermique du PMMA et du PMMA renforcé par 10% de diatomées seules ou par 10% de charges biphasées (diatomées + nanotubes de carbone).
Figure 34 : Dégradation thermique du PMMA et du PMMA renforcé par des diatomées, des charges biphasées et des MWCNT commerciaux à 1%, le tout mélangé à 10 rpm.
Figure 35 : Courbe contrainte-déformation du PMMA et du PMMA chargé à 4 et 10% de diatomées seules et 1, 4 et 10% de charges biphasées (diatomées + nanotubes de carbone).
Figure 36 : Comparaison des propriétés mécaniques du PMMA et du PMMA renforcé par 4 et 10% de diatomées seules.
Figure 37 : Comparaison des propriétés mécaniques du PMMA et du PMMA renforcé par 1, 4 et 10% de charges biphasées (diatomées + nanotubes de carbone).
Figure 38 : Dégradation thermique du SBR.
Figure 39 : Dégradation thermique du SBR et du SBR chargé par des diatomées.
Figure 40 : Dégradation thermique du SBR et du SBR mélangé à des charges biphasées (diatomées + nanotubes de carbone).
Figure 41 : Courbe contrainte-déformation de SBR et SBR chargé à 1, 4 et 10% de diatomées.
Figure 42 : Courbe contrainte-déformation de SBR et SBR chargé à 1, 4 et 10% de biphasés (diatomées + nanotubes de carbone).
Figure 43 : Résistance à la rupture et allongement pour différentes concentrations de biphasés.
Figure 44 : Module de Young pour différentes concentrations de biphasés.
Figure 45 : Mesures électriques sur SBR, SBR + 10% diatomées seules, SBR + 10% charges biphasées (diatomées + nanotubes de carbone).

### Description d'un mode de réalisation

Comme indiqué sur la figure 2, dans un premier temps, le procédé de croissance de CNTs sur substrats de silicium oxydé a été développé. Ce procédé comprend le dépôt de nanoparticules de Ni et de Co par ALD/ CVD/ imprégnation suivi d'une croissance de nanotubes par CCVD. Ce procédé est ensuite transféré sur des diatomées (substrat 3D) à travers un lit-fluidisé. L'intégration du matériau biphasé synthétisé dans des matrices polymères se fera en utilisant une extrudeuse. La fabrication d'éprouvettes pour les caractérisations physiques se fait à l'aide d'une mouleuse par injection et d'une presse hydraulique.

La croissance de nanotubes de carbone requiert un choix pertinent de catalyseurs et de leurs techniques de préparation. Le choix du type de catalyseur est contraint par l'application visée. Le Ni et Co ont été sélectionnés du fait qu'ils n'ont pas a priori un impact négatif dans le vieillissement des pneus contrairement au Fe. Les diatomées qui sont utilisées comme substrat mésoporeux de diverses formes complexes (poudres), toutes les techniques de dépôts ne permettent donc pas de déposer des nanoparticules sur leur surface. Pour cela la technique de dépôt par couches atomiques (ALD a été choisie): elle est la plus adéquate pour déposer des matériaux sur des substrats complexes. L'imprégnation en phase vapeur a aussi été expérimentée.

Du méthanol, de l'éthanol et du propanol pour la réduction de précurseurs métal-organiques tels que le nickel acetylacétonate et le cobalt acetylacétonate dans les procédés ALD sont utilisés. C'est la première fois que les alcools sont employés en ALD comme agents réducteurs pour déposer des couches de Ni et Co (et leurs dérivés tels que les carbures). Un dispositif TFS200 de Beneq comme machine pour les dépôts ALD a été utilisé.

### Dépôt sur substrats plans.

### Substrats.

Les substrats plans utilisés sont constitués d'une plaquette de silicium recouverte d'une couche de 50 nm d'oxyde de silicium. Cette couche d'oxyde modélise bien la surface des diatomées et évite la formation d'alliages tels que les siliciures entre le silicium et les métaux de transition tels que Ni et Co. Cette couche fait office de barrière à la diffusion de ces métaux dans le silicium. Sa croissance se fait par RTCVD (Rapid Thermal Chemical Vapour Déposition) à 1000°C sur un substrat de silicium orienté selon le plan (100).

### Nettoyage.

Les échantillons (silicium oxydé) sont dans un premier temps trempés dans de l'acétone sous ultrasons pendant 10 minutes suivi d'un rinçage à l'eau désionisée. Les échantillons sont plongés ensuite dans de l'éthanol sous ultrasons pendant 10 minutes et sont rincés ensuite avec de l'eau désionisée. Ce nettoyage permet d'éliminer les contaminants organiques et de former suffisamment de groupements hydroxyles -OH en surface de la fine couche de silice pour réagir avec les précurseurs lors des réactions provoquées par la méthode ALD.

### Précurseurs.

Des précurseurs organométalliques sont utilisés : le nickel acétylacétonate et le cobalt acétylacétonate, qui sont des molécules stables et peu coûteuses, peu toxiques et faciles à conserver.

Le nickel et le cobalt acétylacétonate sont achetés dans le commerce (Sigma-Aldrich) sous forme de poudres.

Les poudres seront ensuite chargées dans une canne qui sera introduite dans la source solide chaude. Pour évaporer les précurseurs, cette source est chauffée à 170°C pour le nickel et à 180°C pour le cobalt. Ces températures permettent d'évaporer une grande quantité de matière sans la décomposer. La vapeur sera transportée jusqu'à la chambre de réaction par un flux d'azote.

### Réactants.

Du méthanol, de l'éthanol et du propanol sont utilisés ici comme des réactants pour la réduction des vapeurs de nickel acétylacétonate et de cobalt acétylacetonate déjà adsorbées à la surface du substrat. Ces alcools de pureté 99% sont achetés dans le commerce (Sigma-Aldrich).

La déshydrogénation des alcools est un procédé qui a été mis en place pour la production d'aldéhydes et de cétones. La capacité des alcools à subir la déshydrogénation dépend fortement de leur structure et de la température. Ce procédé est aussi catalysé par les métaux de transition ou par des complexes liés aux métaux de transition.

Le mécanisme de réaction est décrit comme suit : les groupements -OH à la surface de l'échantillon sont partiellement ionisés. L'adsorption de M(acac)₂ à la surface de l'oxyde de silicium est rendue possible par le fait que ces groupements -OH aient accepté le ligand axial du M(II). Ceci entraine une coordination du métal avec un ligand acétylacétonate à la surface et une libération d'une molécule d'acétylacétone. La formation d'une molécule d'acétylacétone est due aux fortes interactions entre les protons des groupements -OH de surface et le système des électrons des ligands acétylacétonate]. Le M(acac) adsorbé est ensuite réduit par des atomes d'hydrogène suite à une interaction avec l'alcool.

Pour chaque procédé ALD, un protocole avec les paramètres de dépôt sous forme d'un programme informatique séquentiel est utilisé. Ce programme commande l'ouverture des vannes pour chaque pulse et purge, les températures et durées de chauffage de la chambre de réaction et des sources chaudes, les flux de gaz porteurs, le nombre de cycles et les temps de pulse pour chaque précurseur. Pour les dépôts sur substrat plan, la température de dépôt a été variée entre 200 et 390°C. Les temps de pulse et de purge allaient de 0,1 à 4s et le choix final dépendait du taux de croissance et de la morphologie visés pour les films. Les flux de gaz vecteurs sont fixés à 300 sccm, suffisants pour transporter les précurseurs jusqu'au réacteur. Le nombre de cycles ALD a été varié de 100 à 4000 en fonction de l'épaisseur de film ou des morphologies à obtenir.

### Dépôt sur diatomées.

Une procédure analogue à celle sur substrat plan est utilisée sauf que les diatomées sont sous formes de poudre, ce qui implique l'utilisation d'un lit fluidisé interne. Les procédés de dépôt sur poudres utilisent les mêmes précurseurs que les dépôts sur substrats plans. Toutefois les paramètres typiques du procédé de dépôt sur diatomées demandent à être optimisés.

### Croissance de nanotubes de carbone.

Comme pour la préparation des particules de catalyseur, la croissance de CNTs est dans un premier temps réalisée sur substrats plan (silicium oxydé) afin de déterminer la valeur optimale des paramètres de croissance. Puis dans un second temps, cette croissance est réalisée sur les diatomées en configuration 3D. La méthode de dépôt chimique catalytique (CCVD) est utilisée dans un appareil MC200 fabriqué par Annealsys pour traiter les substrats plans. En revanche un réacteur en lit-fluidisé est utilisé pour la croissance de CNTs sur diatomées.

### Croissance de CNTs sur substrat plan.

La machine Annealsys MC200 est un réacteur MOCVD (de l'anglais Metal Oxide Chemical Vapour Déposition) à température de parois contrôlée. La configuration de la machine MC200 est la suivante :

Réacteur en inox avec contrôle de température des parois et porte-substrat chauffant pour des plaquettes allant en diamètre jusque 200 mm.

Porte-substrat chauffant et plasma RF avec une température maximale de 850°C.

Un système de vaporisation Kemstream VapBox 4000 avec 4 têtes d'injection de précurseurs liquides et 6 lignes de gaz de procédé.

### Croissance de CNTs sur diatomées.

Les diatomées sont sous forme de poudres de particules comprises entre 1 et 10 microns de diamètre. La croissance de nanotubes de carbone sur ces dernières ne peut donc pas se faire dans une configuration planaire mais dans un réacteur à lit fluidisé.

A partir des matériaux biphasiques (CNTs greffés sur diatomées) selon le protocole abordé ci-dessus et détaillé plus loi, la présente invention s'intéresse à l'élaboration de composites à base de ces matériaux biphasés.

Après avoir fabriqué un matériau biphasé (diatomées + nanotubes de carbone), la prochaine étape est de l'intégrer dans une matrice de polymère. Pour cela il est nécessaire de choisir une technique de mélange qui assure une bonne dispersion des agents de renforts dans la matrice sans les détériorer (cisaillement de CNTs et séparation de leur support silicié). Les deux matériaux sont mélangés par extrusion. Une microextrudeuse est utilisée pour effectuer le mélange des polymères et des charges, et une mouleuse par injection pour la fabrication d'éprouvettes de tests.

### Mélange par extrusion.

Une micro-extrudeuse de modèle « DSM Xplore » micro 15, double-vis, avec une chambre de capacité 15 mL disposant de 6 zones de chauffe (avec une température maximale de 350°C) est utilisée. La vitesse de rotation des vis sans fin est réglable et peut varier de 1 à 250 rpm. Le refroidissement se fait avec un circuit d'eau. En sortie d'extrudeuse, un jonc de 3 mm de diamètre est obtenu.

La température de chauffe et la vitesse de rotation des vis sont d'abord réglées. La température est réglée de telle sorte qu'elle coïncide avec la température de fusion du polymère (180°C pour le PMMA). La vitesse de rotation des vis (qui tournent dans la chambre de mélange) est fixée et en fonction de la densité du polymère et des charges, la force de cisaillement est automatiquement calculée par l'appareil. Il faut ensuite peser les produits à mélanger (le polymère et les charge) puisqu'ils sont solides et les introduire en petites quantités à travers l'injecteur. Le mélange se fait à l'intérieur de la chambre pendant une durée suffisante pour que les produits (5 minutes) s'homogénéisent. Le jonc est récupéré à la fin du mélange.

### Elaboration d'éprouvette.

Après avoir mélangé le polymère et les charges, le produit obtenu est mis en forme dans le but d'en faire des éprouvettes destinées aux analyses mécaniques et électriques. Pour le composite à base de PMMA et de matériau biphasé, une presse à injection est utilisée pour la mise en forme.

Une mouleuse par injection « Thermo scientific HAAKE Minijet II » de dimensions 300mm x 460mm x 710 mm est utilisée. L'injection se fait à l'aide d'un piston avec une pression maximale de 1200 bar, la pression de l'air peut aller jusqu'à 10 bar. Plusieurs moules de formes différentes peuvent être utilisés permettant de réaliser plusieurs types d'échantillons ; les moules peuvent être chauffés jusqu'à 250°C. La pression et la durée de l'injection sont choisies pour s'assurer de la reproductibilité des échantillons.

Les matériaux à injecter sont d'abord introduits et sont fondus dans un cylindre qui peut être chauffé jusqu'à 400°C. Ce cylindre se place au-dessus du moule. Le piston applique une pression sur le cylindre pour pousser son contenant vers le moule à remplir.

### Technique de caractérisation.

### Microscope Electronique à Balayage (MEB).

Au cours de ce travail, les observations MEB ont été réalisées avec un microscope « Helios Nanolab 650 ». Les échantillons de couches minces ont été directement déposés sur un support en aluminium fixé par un ruban adhésif en carbone double faces. La poudre de diatomées sur laquelle sont formés les nanotubes est aussi directement déposée sur le ruban adhésif pour être analysée. Les images MEB montrées dans cette thèse ont été enregistrées avec une tension d'accélération de 2 kV et une intensité de 25 mA.

Le MEB est parfaitement adapté à l'observation des morphologies des couches minces, des particules de catalyseur mais aussi des nanotubes de carbone. Cette technique renseigne sur la densité, la taille des nanoparticules et des nanotubes de carbone, permettant d'imager des structures de taille allant jusqu'à 10 nm. Le MEB renseigne aussi sur la dispersion des nanotubes dans la matrice polymère, une information cruciale pour la compréhension des propriétés physiques du composite.

### Microscope Electronique à Transmission (MET).

De par sa haute résolution spatiale, le MET permet d'accéder à des informations de l'ordre atomique. Il permet de distinguer les nanotubes monoparoi ou multiparois et de voir les défauts qui sont sur les tubes. Avec le MET, il est possible des distinguer les structures suivantes : nanotubes, fibres, structure en bambou...Cette imagerie permet également d'évaluer comment les nanotubes sont dispersés dans le PMMA. Les analyses MET ont été faites avec un 'LEO 922 OMEGA' équipé d'un pistolet à émission de champ avec une tension d'accélération pouvant aller jusqu'à 200 kV, de détecteurs EELS (spectromètre de pertes d'énergie d'électrons), Rayons X, SE (électron secondaire), et BSE (électrons retro-diffusés). La résolution de l'instrument est de 0.29 nm.

Les échantillons de composite (PMMA+ biphasés) ont été découpés en fines tranches d'épaisseur variant entre 70-100 nm par un microtome. Les échantillons sous forme de poudres ont été directement déposés sur la grille TEM.

### Spectroscope de photoélectrons X (XPS).

L'XPS est une technique d'analyse chimique de surface avec laquelle l'échantillon est irradié par des rayons X monochromatiques. Ces derniers, par effet photoélectrique, provoquent l'ionisation des atomes. Celle-ci permet d'accéder à des informations telles que la composition chimique des matériaux (couches minces). L'XPS est parfaitement adaptée pour connaître la composition chimique des nanoparticules de catalyseur et des films minces métalliques qui ont été utilisés pour la catalyse de la croissance de nanotubes de carbone. Les analyses ont été faites avec un dispositif Kratos axis ultra DLD équipé d'un tube à rayon X (Al Kα d'énergie hv= 1486.6 eV) avec une puissance de 150 W; analyseur d'énergie constitué de deux électrodes hémisphériques ; un système d'acquisition et de traitement de données permettant l'acquisition spectres à haute résolution (énergie de passage 40 eV) et de spectres globaux (energie de passage 160 eV). L'instrument dispose d'une résolution spatiale de 10 µm (spectroscopie) et 3 µm (imagerie) ; la limite de sensibilité est de 0.5. Les énergies de liaisons sont calibrées sur l'énergie de liaison du carbone 1s.

Les propriétés mécaniques sont étudiées à travers les tests de traction sur les éprouvettes fabriquées par injection. Ces tests de traction fournissent l'évolution de la contrainte en fonction de la déformation. Le comportement mécanique du matériau se manifeste par les propriétés de la courbe contrainte-déformation qui permet d'extraire la résistance à la traction, la limite élastique et la déformation maximale (allongement) du matériau avant rupture. Cette courbe permet aussi de déterminer trois domaines correspondant à la zone d'élasticité, la zone de déformation plastique et la zone rupture du matériau.

Pour mesurer la résistivité des matériaux, la méthode Van der Pauw a été utilisée.

La stabilité thermique des matériaux composites a été mesurée à travers leur comportement sous l'effet de la chaleur. L'analyse thermogravimétrique (TGA) est souvent utilisée pour déterminer les caractéristiques des matériaux qui sont liées à leur perte de masse. Cette perte de masse est due à la décomposition, à l'oxydation...des composants du matériau sous l'effet de la température. La TGA a été utilisée pour investiguer la stabilité thermique des composites à travers leur perte de masse. L'appareil utilisé est un NETZSCH-STA 409 PC, avec un flux d'air de 100 cm³.min⁻¹ dans un creuset en aluminium contenant 20-25 mg de l'échantillon. Les mesures ont été faites dans des conditions dynamiques avec une rampe de température de 10°C.min⁻¹.

Afin de déterminer les conditions optimales de croissance sur les diatomées d'une haute densité superficielle de nanotubes multi-parois avec aussi peu de défauts que possible, le procédé a été développé dans un premier temps sur des substrats plans. Un substrat de silicium oxydé comportant en surface une couche de 50 nm d'oxyde de silicium SiO₂ a été sélectionné afin de reproduire la nature chimique de la coque des diatomées qui est constituée d'environ 50 nm d'oxyde de silicium.

La préparation des catalyseurs de nickel et de cobalt est décrite. L'ALD de Ni(acac)₂et de Co(acac)₂ réduits par des alcools est utilisée sur des substrats d'oxyde de silicium. Ce procédé a été développé auparavant en CVD [113] mais a été développé pour la première fois en ALD. La croissance de nanotubes de carbone par CVD sur des nanoparticules catalytiques préparées par ALD, CVD et imprégnation en phase vapeur est ensuite présentée.

### Préparation des catalyseurs.

La croissance de nanotubes de carbone est catalysée par des nanoparticules de cobalt et de nickel préparées par la technique ALD.

### Dépôt de nickel par ALD.

Dans le but de caractériser leur composition chimique, leur structure cristalline et leur morphologie, des films d'épaisseur allant de 10 à 100 nm ont été déposés. Du nickel acétylacetonate comme précurseur et des alcools (méthanol, éthanol et propanol) comme agents de réduction ont été utilisés. Les films ont été déposés sur du silicium oxydé thermiquement à 1100°C, avec une épaisseur de 50 nm de SiO₂ suffisante pour empêcher toute diffusion du nickel dans le substrat. Le Ni(acac)₂ est sous forme de poudre et a été sublimé à 180°C ; quant aux alcools ils ont été évaporés à température ambiante. La purge du réacteur est assurée par un flux d'azote continu de 300 sccm. Un cycle ALD comprend un pulse de Ni(acac)₂ (temps de pulse t_{Ni}) et un pulse d'alcool (temps de pulse t_{alcool}) séparés par une purge du réacteur (temps de purge t_{P}). Le temps de purge est fixé à 2s et le temps de pulse de Ni(acac)₂ et d'alcools varient entre 0.1 et 4s. La température de dépôt varie entre 200 et 300°C.

### Croissance des films.

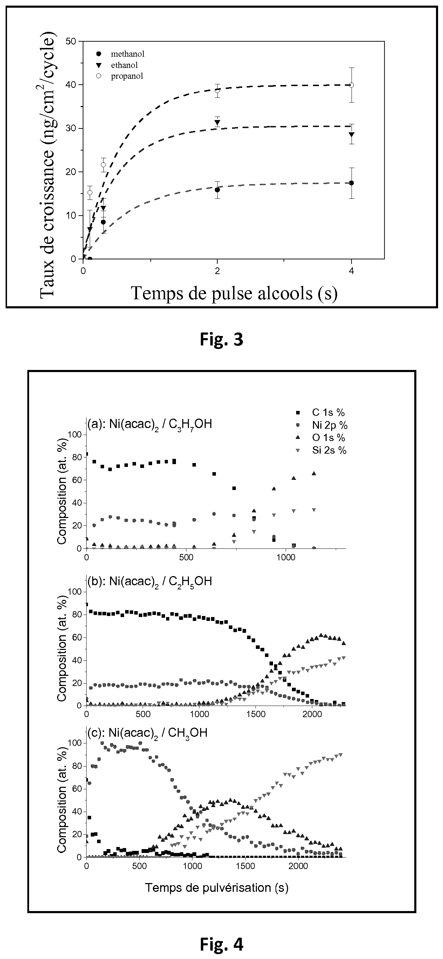

La figure 3 montre l'augmentation du taux de croissance des films (défini ici en ng/cm²/cycle) en fonction du temps d'injection d'alcools (t_{alcool}) pour les trois alcools de longueur de chaîne alkyle croissante. Cette augmentation a été déjà observée par Premkumar et ses collaborateurs dans le cadre d'un procédé CVD utilisant le Co(acac)₂ comme précurseur (Premkumar P. A., et al., Chem. Vap. Depos., 2007, 13, 219-226). Ceci est attribué à la dissociation incomplète de l'alcool durant le procédé conduisant à une incorporation du carbone dans le film et par conséquent à l'augmentation de la masse du film. Par ailleurs la réduction du nickel acétylacetonate adsorbé à la surface par des alcools se fait via les atomes d'hydrogène provenant des groupements alcools. La réactivité des alcools primaires a été étudiée en fonction de la longueur de leur chaîne : il a été démontré que le propanol fournit préférentiellement un proton comparativement aux autres alcools (Premkumar P. A., et al., Chem. Mater., 2007, 19, 6206-6211). Ceci pourrait aussi expliquer le fait que le taux de croissance obtenu avec le propanol est supérieur à celui obtenu avec l'éthanol, lui-même supérieur à celui obtenu avec le méthanol.

### Composition chimique et structures cristallines des films.

L'analyse chimique des films a été conduite en utilisant l'XPS, associée à un bombardement ionique afin de sonder la composition en épaisseur. Ainsi des quantités élevées de carbone (70-80%) ont été détectées à la surface et en profondeur dans les films synthétisés avec l'éthanol et le propanol comme agents de réduction (Figures 4a et 4b). Par contre en utilisant le méthanol, des films de nickel de pureté avoisinant 95% ont été obtenus, et le carbone est principalement présent à la surface du film sous forme de contaminations carbonées (cette contamination est usuelle en XPS et provient des molécules atmosphériques qui peuvent s'adsorber à la surface des échantillons lors de leur manipulation) (Figure 4c).

L'augmentation de la quantité de carbone est corrélée avec celle du taux de croissance obtenu en utilisant l'éthanol et le propanol par rapport au méthanol.

Il a été montré que la déshydrogénation des alcools primaires fournit de l'hydrogène, du CO, du CO₂, des aldéhydes et d'autres fragments provenant de leur décomposition. L'utilisation du méthanol qui n'a qu'un seul atome de carbone dans sa structure est donc favorable pour réduire la contamination du film en carbone et permet alors d'obtenir la croissance d'un film métallique de nickel.

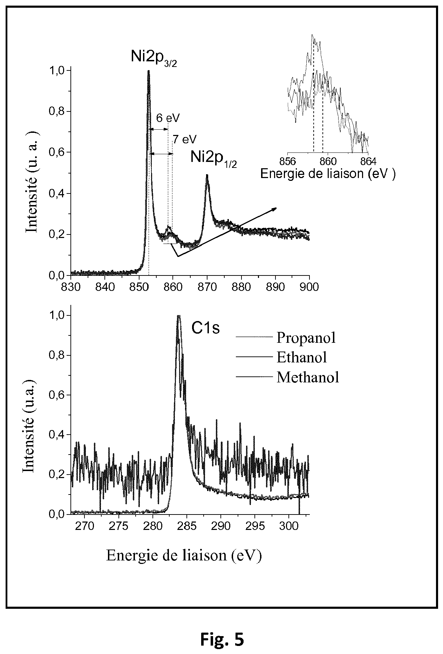

Le carbone est le principal élément présent à la surface du film formé avec le méthanol comme agent réducteur mais ensuite dans le cœur du film, le nickel devient l'élément majoritaire jusqu'à ce que l'on atteigne la couche de silice. En revanche, pour les films déposés en utilisant l'éthanol et le propanol, le carbone est l'élément dominant en surface et dans le film, jusqu'à la couche de silice. Les spectres XPS des niveaux de cœur du carbone et du nickel sont montrés sur la figure 5. La structure fine du pic du niveau de cœur du Ni2p montre que cet élément est sous forme de nickel réduit (métallique) pour tous les films. L'énergie de liaison du Ni 2p3/2 dans sa phase métallique a été reportée à 852.8 eV et est différente de celle de ses phases oxydes (854,6 eV pour NiO ; 855,7 eV pour Ni₂O₃ et 856,45 eV pour le Ni(OH)₂).

Le spectre XPS du Ni 2p3/2 dans sa phase métallique possède un pic satellite à +6 eV qui a été attribué aux pertes énergétiques des plasmons et aux transitions inter-bandes. Ce pic satellite est retrouvé sur le spectre Ni 2p du film déposé en utilisant le méthanol comme agent de réduction (Figure 5 en insert). Avec l'éthanol ou le propanol, les pics satellites sont décalés de 1 eV vers les grandes énergies de liaison. Cet effet a également été observé sur un composite de carbure de nickel et de carbone déposé par un procédé de pulvérisation. Les auteurs l'ont attribué à la présence de carbone dans la phase cristalline du nickel modifiant l'écrantage électrostatique des électrons 2p (Abrasonis G., et al., X-Ray spectroscopic and magnetic investigation of C, 2008, 112, 12628-12367). En se basant sur ces résultats, il est conclu que l'utilisation du propanol ou de l'éthanol mène à la formation de carbure de nickel mais l'utilisation du méthanol conduit à la formation du nickel métallique.

### ALD du cobalt.

La structure chimique et la morphologie des films déposés utilisant le cobalt acétylacétonate réduits par le méthanol, l'éthanol et le propanol sont présentées.

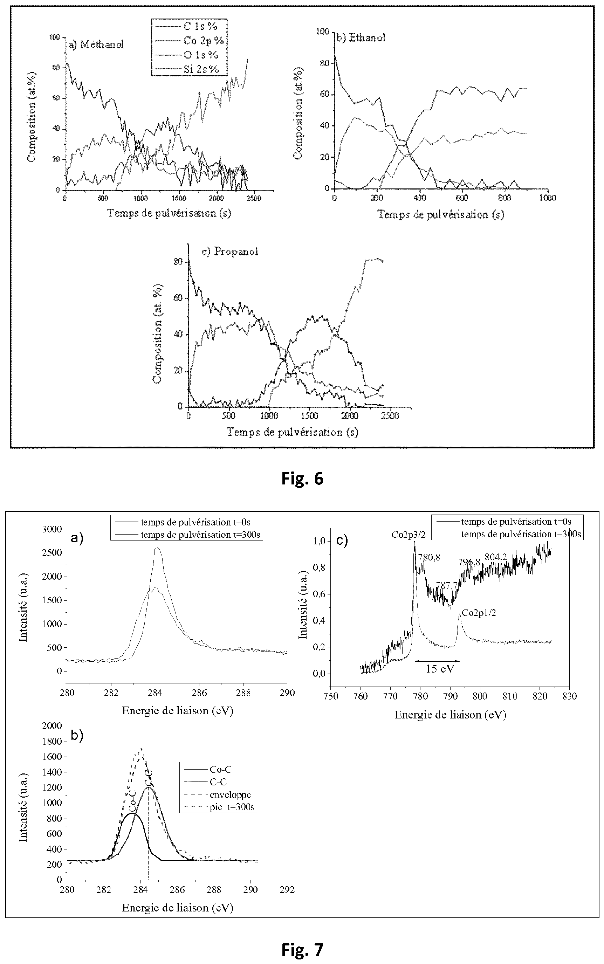

La figure 6 montre les analyses XPS de films déposés à partir du Co(acac)₂ et des trois alcools comme agents de réduction. Contrairement aux films de nickel, le carbone est présent dans tous les films avec une concentration supérieure à 50%. La concentration de cobalt quant à elle croît en fonction de l'alcool utilisé : 25% avec le méthanol, 40% avec l'éthanol et 50% avec le propanol. Aucun des alcools utilisés ne réduit complètement le Co(acac)₂ jusqu'à l'obtention d'un film purement métallique. Les films déposés avec le propanol ont été sélectionnés pour étudier la structure cristalline des dépôts les plus épais.

La figure 7 montre les spectres C 1s et Co 2p des films déposés à 350°C avant et après bombardement ionique de la surface. L'intensité du pic de carbone C 1s à la surface du film (temps de bombardement 0s) est plus élevée que celle dans le film (temps de bombardement 300s) à cause de la contamination surfacique à l'air ambiant. Le maximum et la forme du pic sont respectivement décalés et élargis après 300s de bombardement. En faisant une décomposition spectrale en utilisant une fonction mixte Gaussienne-Lorentzienne, la présence de deux contributions à 284.4 et 283.5 eV est démontrée (Figure 7b). Celles-ci correspondent respectivement aux liaisons C-C et C-Co. Ceci indique qu'une fraction du carbone contenu dans le film est liée avec le cobalt pour former une phase de type carbure. Les énergies de liaison du Co 2p3/2 et Co 2p1/2 (Figure 7c) après 300s de bombardement sont mesurées à 778.4 et 793.4 eV et correspondent à la phase métallique du cobalt. En plus de la phase métallique, deux épaulements sont mesurés à 780.8 et 796.8 eV associés à leur satellite respectif à 787.7 et 804.2 eV et correspondent à une phase d'oxyde de cobalt.

Il a été démontré que l'ALD du Ni(acac)₂ réduit par le méthanol peut aboutir à une phase de Ni métallique et de carbure de Ni quand il est réduit par l'éthanol et le propanol. La réaction du Co(acac)₂ avec les trois alcools produit systématiquement du carbure de cobalt, y compris avec le méthanol. Cette phase carbure de cobalt n'est cependant pas rédhibitoire quant à son utilisation comme catalyseur de croissance de nanotubes de carbone. Enfin, le procédé de croissance de CNTs utilise une étape de réduction à l'hydrogène préliminaire à la croissance permettant l'activation des catalyseurs métalliques ou carbonés.

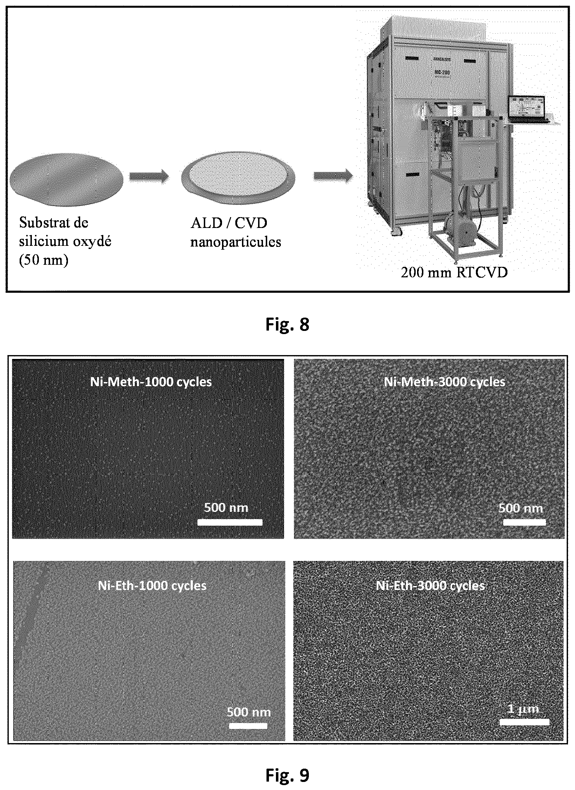

La figure 8 montre la procédure de croissance de nanotubes de carbone sur un substrat plan.

### Préparation des particules catalytiques de nickel

Des couches de nickel déposés à partir du Ni(acac)₂ réduit par le méthanol et des couches de carbure de Ni à partir du Ni(acac)₂ réduit par l'éthanol ont été utilisées. Pour chaque type, des conditions de non saturation pour aboutir à des nanoparticules bien séparées à la surface du substrat et des conditions de saturation pour déposer un film qui couvre bien la surface du substrat ont été utilisées. Pour les conditions de non saturation, les paramètres d'utilisation sont les suivants : 1s de temps de pulse Ni(acac)₂, 1s de temps de pulse de l'alcool, 2s de purge et 1000 cycles à 300°C. Pour les conditions de saturation, les paramètres d'utilisation sont les suivants : 2s de temps de pulse Ni(acac)₂, 2s de temps de pulse des alcools, 2s de purge et 3000 cycles (∼30nm pour l'éthanol, -15 nm pour le méthanol). La figure 9 montre les différentes morphologies des dépôts en fonction des paramètres de saturation. Le Ni-Meth 1000 cycles montre de plus petites particules comparé au Ni-Eth-1000 cycles, les dépôts de nickel à partir du Ni(acac)₂ réduit par le méthanol disposent de plus faible taux de croissance. L'épaisseur du film Ni-Eth-3000 cycles est de ce fait plus élevée que celle du Ni-Meth-3000 cycles.

### Croissance de nanotube catalysée par le nickel.

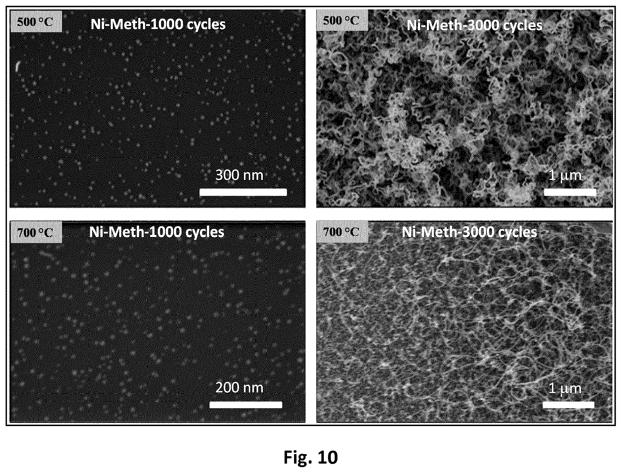

La figure 10 montre les clichés MEB des structures carbonées synthétisées à 500 et 700°C, 10 minutes réduction à l'hydrogène de concentration (H₂ : N₂) = 10 : 90. Le temps de croissance est de 10 minutes, la concentration d'acétylène (C₂H₂ : N₂) = 10 : 90. La pression dans la chambre de réaction est de 13 mbar. La croissance a été faite sur des nanoparticules de nickel déposées par ALD à 1000 et 3000 cycles.

Les essais de synthèse de nanotubes faits sur les particules déposées à 1000 cycles à 500 et 700°C n'ont pas été fructueux. Sur les échantillons déposés à 3000 cycles, des structures tortueuses ont été obtenues comme précédemment à 500°C. Par contre à 700°C, des nanotubes ont été obtenus mais avec une densité superficielle faible comparée aux tapis de nanotubes qui sont obtenus avec le cobalt.

Il a été démontré que l'ALD du Ni(acac)₂ et de l'éthanol donnait du carbure de nickel. En utilisant les mêmes conditions que précédemment, il n'y pas eu de croissance sur les échantillons déposés à 1000 cycles ALD à 700°C et quelques structures (fibres ou tubes) bien dispersés à 500°C. Pour les échantillons déposés à 3000 cycles, quelques structures (certainement des fibres) à la surface ont été observées. Par contre à 700°C, il n'y pas de croissance à part quelques longues structures à la surface.

### Préparation des particules catalytique de cobalt.

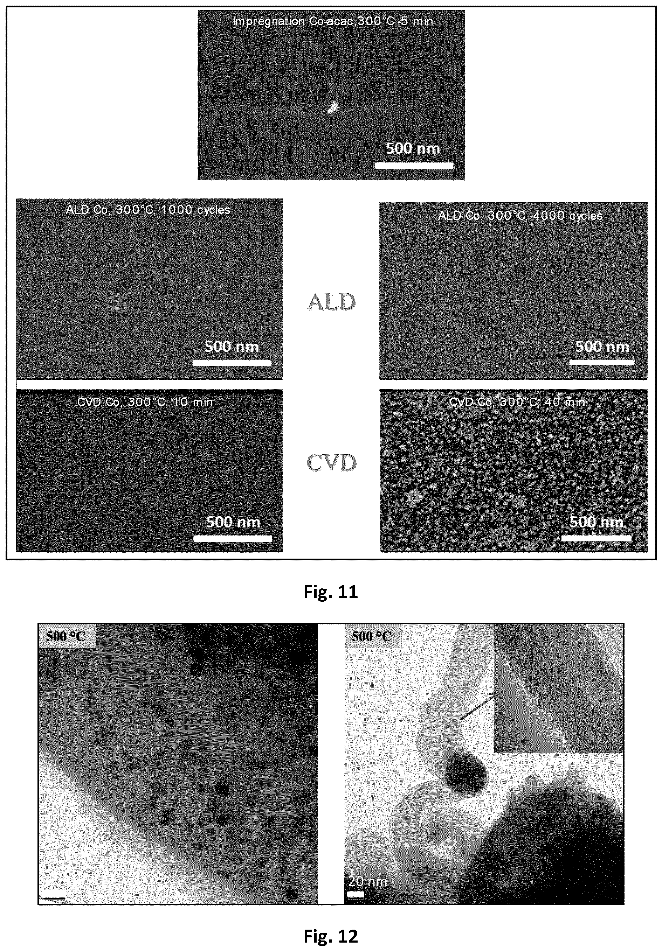

La figure 11 montre différents types de films de cobalt déposés par trois procédés différents : la CVD, l'ALD et l'imprégnation par phase vapeur. Les dépôts par CVD ont été faits à partir d'une solution de Co(acac)₂ et de l'éthanol. La poudre de Co(acac)₂ est dissoute dans de l'éthanol pour faire une solution à 5 mmol.L⁻¹. Cette solution est ainsi injectée durant 10 ou 40 min sur un substrat d'oxyde de silicium chauffé à 300°C. Les dépôts ALD ont été réalisés en faisant réagir du Co(acac)₂ et de l'éthanol à 1s de temps d'injection de Co(acac)₂, 2s de temps d'injection d'éthanol, 2s de temps de purge. 1000 cycles et 4000 cycles ont été utilisés. L'imprégnation en phase vapeur consiste à injecter pendant 150s la vapeur de Co(acac)₂ sublimé à 155°C.

Comme attendu, dans le cas de l'imprégnation, aucune nanoparticule n'est observée en MEB. En revanche la figure 11 montre la présence de telles nanoparticules pour l'échantillon ALD fait à 1000 cycles (4 à 8 nm de diamètre en moyenne), et celui fait à 4000 cycles (entre 6-8 nm de diamètre moyen). Ces valeurs sont extraites à partir des clichés MEB par le logiciel image-J. Concernant les échantillons déposés durant 10 et de 40 minutes par CVD une nette différence de morphologie a été remarquée. Après 10 min, une distribution homogène de nanoparticules (de diamètre moyen 2 à 4 nm) a été observée alors que 40 minutes de dépôt conduit à la coalescence des nanoparticules préalablement formées et à la formation d'agrégats.

### Croissance de nanotube sur les particules déposées par CVD.

La croissance de nanotubes de carbone a été faite en utilisant d'abord une étape de réduction à l'hydrogène de 10 minutes de concentration (H₂ : N₂) = 10 : 90 (rapport de pression partielle), suivie d'une étape de croissance utilisant l'acétylène comme source de carbone. Le temps de croissance est de 10 minutes, la concentration d'acétylène (C₂H₂ : N₂) = 10 : 90. La pression totale dans la chambre de réaction est de 13 mbar. La température de croissance est variée de 500 à 800°C.

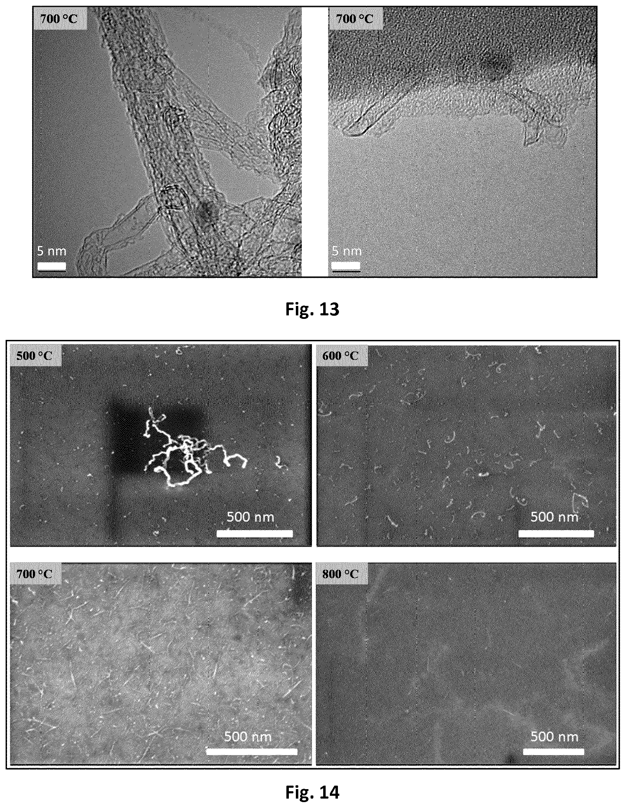

Les figures 12 et 13 montrent les clichés MET des échantillons synthétisés à 500°C et 700°C, respectivement. La figure 12 révèle des structures de type fibre de carbone de gros diamètre (∼ 80 nm) et de longueur typique ∼150nm. A 500°C, la nanoparticule de Co (clairement observée sur le cliché 18 panel gauche) catalyse une croissance « tip-growth » de fibres de carbone. Le régime de croissance de CNTs requiert des températures minimales de l'ordre de 700°C comme confirmés par les photographies de la figure 13. Pour cette température, les structures caractéristiques de nanotubes de carbone mono et double parois sont mises en évidence. Leur diamètre varie entre 1 et 3 nm avec quelques défauts structurels notamment observés sur les nanotubes à double parois. Il est remarquable de noter que le régime de croissance est significativement modifiée avec la température compte tenu du passage d'un mode « tip-growth » à 500°C pour les fibres de carbone à un mode « bottom-growth » à 700°C pour les nanotubes. En effet, pour ces derniers, aucune particule n'est observée aux extrémités libres des nanotubes.

Ces observations confirment les précédentes analyses statistiques et soulignent la nécessité de travailler à des températures minimales de 700°C lorsque des catalyseurs de Co synthétisés par CVD sont usités.

Croissance de nanotube sur les particules déposées par imprégnation en phase vapeur.

La figure 14 montre les images MEB de nanotubes synthétisés à différentes températures sur des substrats imprégnés de vapeur de Co(acac)₂ sublimé à 170°C. La pression dans la chambre de réaction est de 13 mbar. La température est variée de 500 à 800°C.

A 500°C, quasiment aucune croissance n'est observée, seulement de très petites structures à quelques endroits de l'échantillon ainsi qu'une structure épaisse (>30nm) et tortueuse sont présentes. A 600°C, il y a une distribution plus dense de petites structures qui peuvent être associées soit à des nanofibres, soit à des nanotubes tortueux. A 700°C, des structures plus fines, de forte densité et bien dispersées sont obtenues. Des structures similaires à 800°C sont observées mais avec une densité beaucoup plus faible qu'à 700°C.

Il est donc conclu qu'à 500 et 600°C, l'énergie d'activation de l'activité de catalyse n'a pas été atteinte.

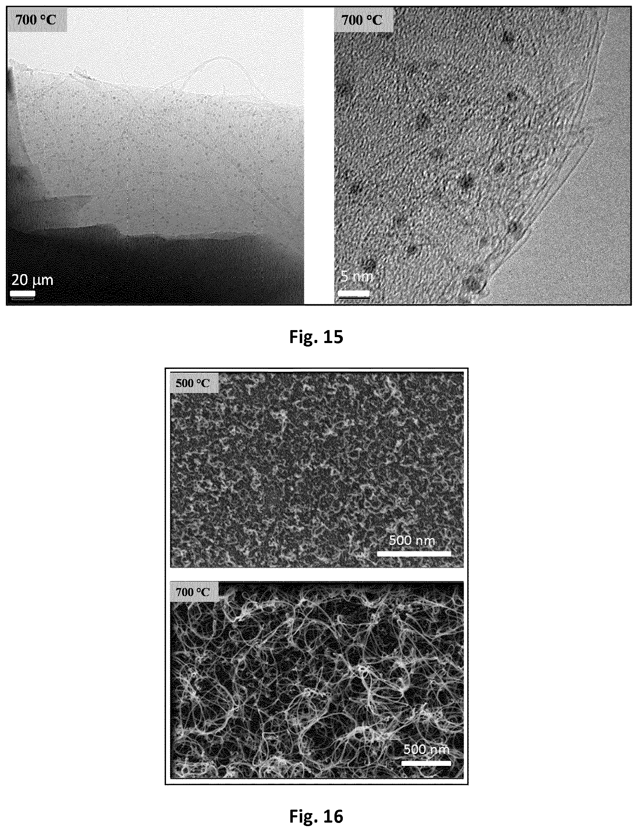

La figure 15 montre la morphologie des nanotubes obtenus à 700°C. La présence de faisceaux de nanotubes mono-paroi qui semblent bien cristallisés et sans trop de particules ou de dépôts carbonés amorphes ou d'oignons est observée.

### Croissance de nanotube sur les particules déposées par ALD.

La figure 16 montre les images MEB de nanotubes de carbone synthétisés à 500 et 700°C. Comme précédemment, à 500°C, la présence de structures fibreuses est soupçonnée. Par contre à 700°C, un tapis dense de nanotubes qui couvrent toute la surface de l'échantillon est obtenu.

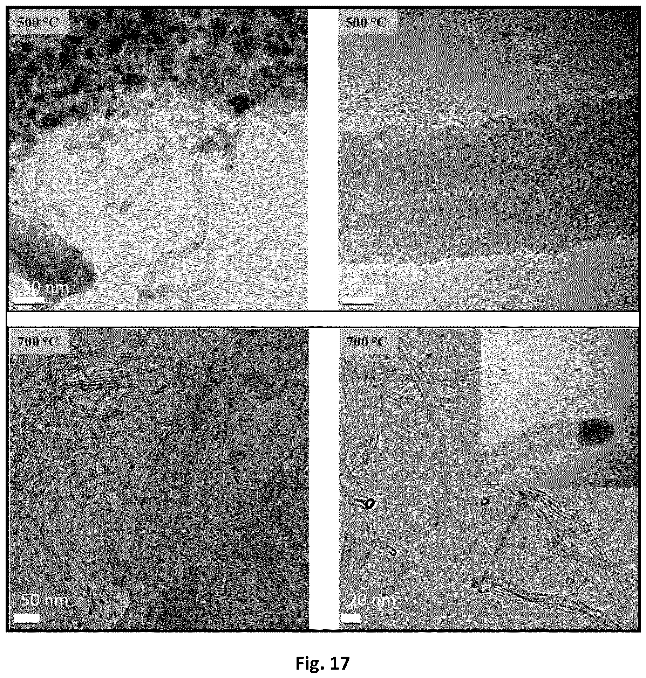

Les images MET présentées à la figure 17 confirment les structures fibreuses soupçonnées sur l'échantillon synthétisé à 500°C. A 700°C, le tapis de nanotubes correspond à des CNTs multi-parois avec quelques défauts sur les parois extérieures et de diamètre compris entre 15 et 20 nm. Le mode de croissance est de type « top-growth ».

Pour résumer, un mélange de nanotubes mono et double-parois à partir de 600°C est obtenu avec les échantillons CVD. La croissance de nanotubes de carbone sur les échantillons réalisés par imprégnation aboutit à des fagots de tubes mono-paroi et quelques tubes double parois. L'échantillon réalisé par ALD 4000 cycles (de taille moyenne des particules autour de 8 nm) quant à lui fournit un tapis de nanotubes multi-parois de type « haute ». Ces résultats confirment que la croissance de mono ou multi-parois est aussi influencée par la taille des particules catalytiques, même si d'autres paramètres tels que la température, la concentration de la source carbonée et la réduction jouent également un rôle important.

### Taille des catalyseurs et morphologie.

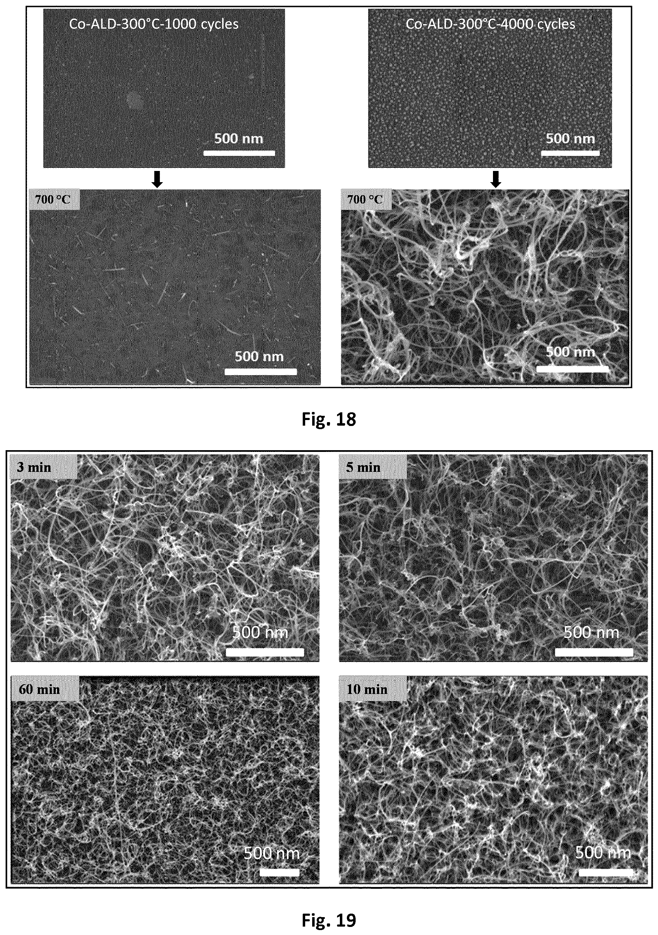

L'échantillon réalisé à 1000 cycles d'ALD donne les mêmes structures que celles observées sur les CVD à 700°C, des nanotubes mono ou doubles parois, ce qui corrèle bien l'influence de la taille des particules qui est environ 4 à 8 nm de diamètre moyen. Par ailleurs l'échantillon à 4000 cycles donne un tapis de tubes multi-parois comme observé à la figure 18.

### Temps de croissance.

La figure 19 montre qu'après 3 minutes de croissance (à paramètre constant), un tapis de nanotubes se forme déjà. Le tapis devient de plus en plus touffu avec l'augmentation du temps de croissance.

### Temps de réduction.

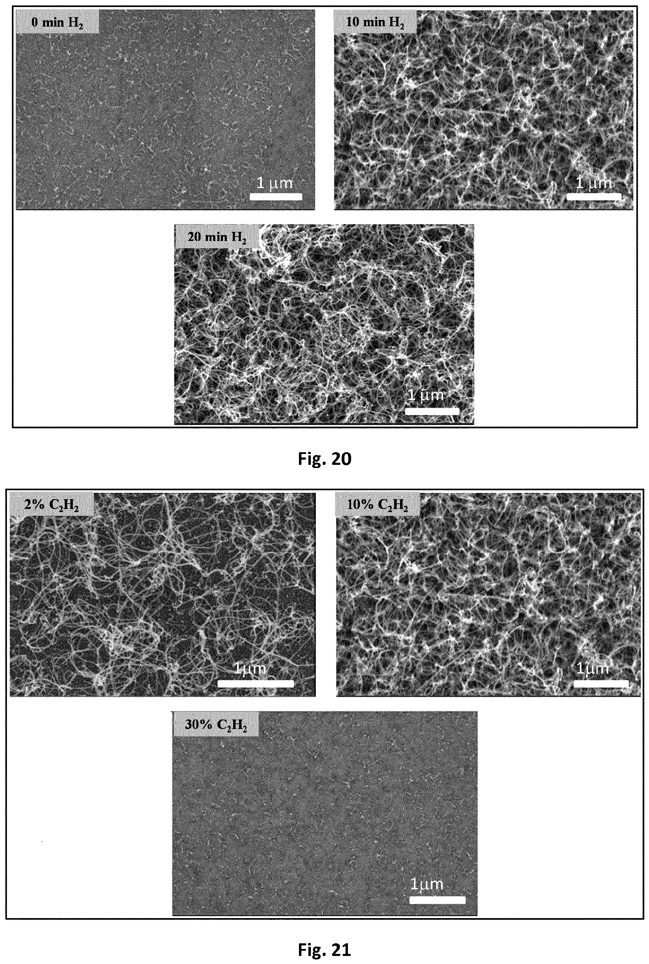

Le temps de réduction à l'hydrogène précédent l'étape de croissance a été investigué ici en gardant tous les paramètres constants. La figure 20 montre les images MEB de nanotubes synthétisés à des temps de réduction de 0, 10 et 20 minutes. Sans étape de réduction, une faible densité de nanotubes à la surface de l'échantillon est remarquée. Par contre pour 10 et 20 minutes, un tapis de nanotubes multi-parois est généré. Le rôle de la réduction à l'hydrogène est de nettoyer la surface des particules et de réduire les particules oxydées. En l'absence d'hydrogène, les particules oxydées et celles contaminées à la surface ne sont pas activés, ce qui conduit à une très faible densité de nanotubes.

### Concentration en acétylène.

La figure 21 montre les images MEB de nanotubes synthétisés à différentes concentrations d'acétylène en gardant les mêmes conditions que précédemment. Une concentration de 2%, 10% et 30% d'acétylène dans de l'azote a été utilisé, et il a été observé que cette concentration influence de manière significative la densité superficielle des nanotubes. A 2%, le procédé fournit une densité beaucoup plus faible qu'à 10%. Dans ces conditions, il n'y a pas suffisamment d'atomes de carbone pour réagir avec les particules. Il a été montré par ailleurs qu'à faible concentration du précurseur, le taux de carbone disponible réagissant avec les particules catalytiques est faible conduisant à une faible croissance. Par ailleurs à 30%, une faible densité de nanotubes est également obtenue: à forte concentration d'acétylène, la concentration d'atomes de carbone disponible devient très élevée, le taux de dissolution devient élevé par rapport au taux de précipitation et au taux de diffusion. Ceci entraine une accumulation de carbone à la surface de la particule et accélère sa sursaturation et sa perte d'activité de catalyse, ce qui conduit à une faible densité de nanotubes.

Les particules de carbure de cobalt ont été déposées sur des diatomées par ALD en configuration lit-fluidisé interne. Le précurseur utilisé est l'acétylacétonate de cobalt, et l'alcool réducteur est l'éthanol.

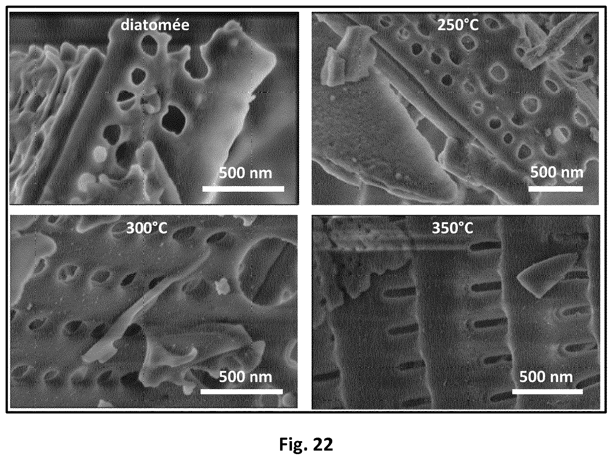

La figure 22 montre les images MEB de dépôts réalisés à 250, 300 et 350°C. Le temps d'exposition des précurseurs (acétylacétonate de cobalt et éthanol) était de 20s chacun ainsi que le temps de purge, le nombre de cycles était de 115. Aucun dépôt n'a été observé à 250°C, ce n'est qu'à partir de 300°C que la croissance de nanoparticules de carbure de cobalt sur la surface des diatomées est observée. Lors d'une croissance par ALD, l'énergie d'activation doit être suffisante pour permettre la croissance des premières couches atomiques. Le rôle de la température est ainsi de permettre l'activation de l'adsorption des précurseurs à la surface du substrat et la réaction entre les deux précurseurs. De plus, la hausse de la température favorise la migration de surface des atomes de cobalt et conduit à la formation de films ou de nanoparticules.

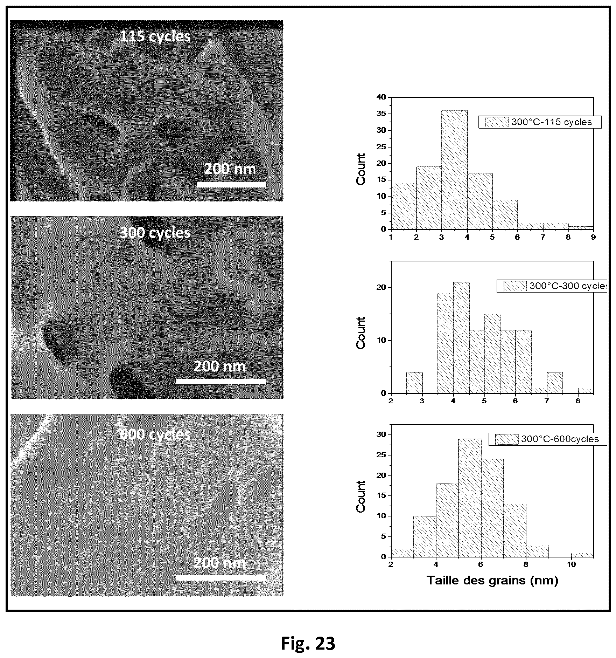

La morphologie des dépôts réalisés à 300°C en variant le nombre de cycles est illustrée à la figure 23. A 115 cycles, des particules moins denses et bien dispersées sont observée. La figure 23 reporte également la distribution de la taille des particules en fonction du nombre de cycles obtenue après extraction et traitement des images MEB par le logiciel Gwyddion. De 115 à 600 cycles d'ALD, il y a une légère augmentation de la taille moyenne des particules. Ceci est conforme avec les résultats rapportés dans la littérature qui montrent que dans les procédés ALD, la taille des particules augmente avec le nombre de cycle et par conséquent l'épaisseur des films.

La taille et la densité des particules catalytiques seront des paramètres qui influent beaucoup sur les dimensions et la densité des nanotubes de carbone. Ces deux caractéristiques du catalyseur peuvent être contrôlées à partir des paramètres du procédé ALD.

### Croissance de nanotube de carbone.

### Influence de la température de croissance.

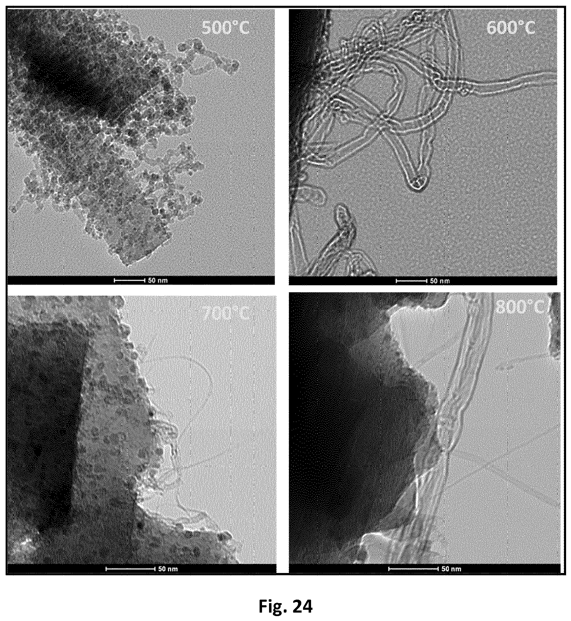

La figure 24 montre les images MET des tubes formés à différentes températures. A 500°C, les images montrent des structures courtes et tortueuses. A 600°C, l'échantillon est essentiellement constitué de nanotubes multi-parois avec de nombreux défauts induisant des coudes importants. A 700°C, un mélange de nanotubes mono-paroide petit diamètre et de multi-parois est observé. L'échantillon synthétisé à 800°C montre aussi des nanotubes mono-paroi et multi-parois de plus gros diamètre comparés à ceux de l'échantillon à 700°C.

### Influence du temps de croissance.

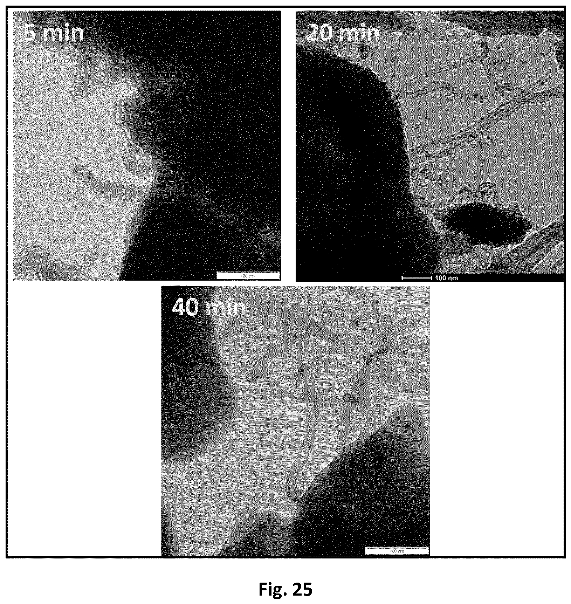

L'influence du temps de croissance a été étudiée à la température de 600°C, avec un temps de réduction de 20 minutes sou hydrogène, une croissance à l'aide d'un mélange 20% d'hydrogène dans du N₂ et 20% d'acétylène dans du N₂. La figure 25 montre les clichés MET de la morphologie des nanotubes à 5, 20 et 40 minutes de croissance. A 5 minutes de croissance, les tubes sont relativement courts comparés à ceux synthétisés à 20 minutes et à 40 minutes. Le nombre de nanotubes semble être plus important à 40 min de croissance mais cela ne confirme pas que les diatomées sont des structures en 3D et que les clichés TEM ne sont qu'une projection en 2D. Il a été démontré par plusieurs auteurs que la densité et la longueur des nanotubes augmentent avec l'augmentation du temps de croissance.

A partir des images MET, il est possible de constater que la majorité des nanotubes présents sont des MWNTs.

### Influence de la concentration d'acétylène.

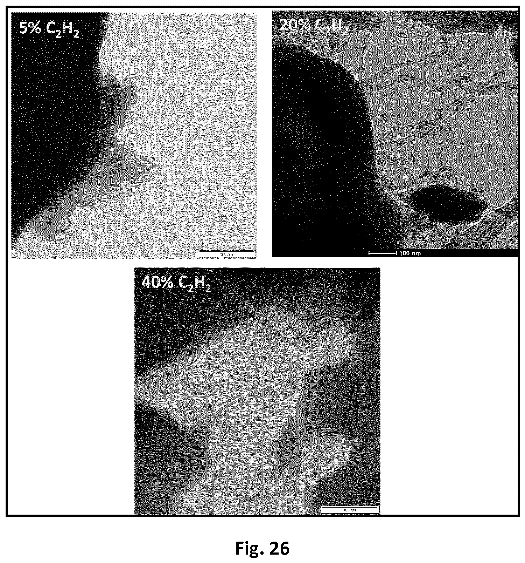

Trois concentrations d'acétylène (5, 20 et 40%) dans du N₂. La figure 26 montre les images MET de la morphologie des nanotubes en fonction de cette concentration. A 5% d'acétylène, un très faible taux de croissance est remarqué et il y a très peu de nanotubes. Des tubes MWNT sur les échantillons à 20 et 40% sont observés. L'augmentation de la concentration de la source carbonée favorise donc la croissance de MWNT.

### Influence du temps de réduction.

En gardant tous les paramètres constants, la température à 600°C, le temps de croissance à 20 minutes, la concentration d'acétylène à 20% molaire dans du N₂, le temps de réduction à l'hydrogène est varié à 0, 5 et 20 minutes pour étudier son influence sur la morphologie des nanotubes.

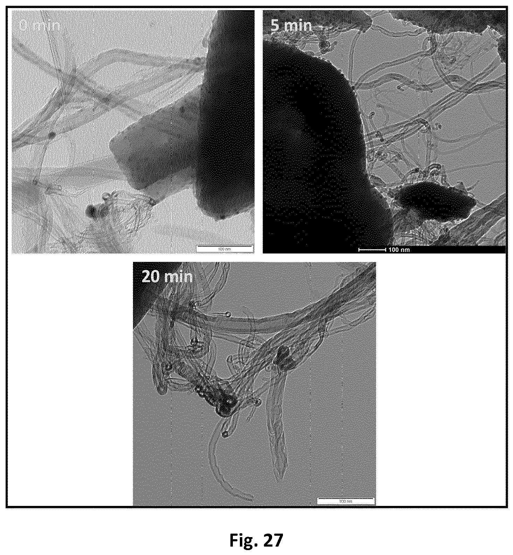

Les images TEM présentées à la figure 27 montrent des MWNTs. Des points noirs sur les CNTs sans réduction hydrogène sont observés. Il s'agit certainement de particules métalliques. A 20 minutes les nanotubes ont peu de défauts et semblent être moins pollués par ces particules.

### Croissance de nanotubes de carbone sur lit-fluidisé externe (monoétape).

Dans la partie précédente, il a été démontré l'influence des paramètres de croissance sur la morphologie des nanotubes mais ceci a été fait sur de petites quantités de poudres de diatomées (quelques mg). Il est ainsi impossible pour des raisons liées à la limitation de la machine d'effectuer des dépôts ALD de nanoparticules sur une grande quantité de poudres (5g). Un système de lit fluidisé externe a été mis en place pour déposer les particules de cobalt par imprégnation en phase vapeur suivi du procédé de croissance de nanotubes sur 5g de poudre de diatomées sans remettre à l'air le système, évitant ainsi tous risques de contamination par des particules non-désirées, comme par exemple la poussière. Ce procédé a été nommé synthèse mono-étape et correspond également à un procédé de synthèse monotope.

Le Co(acac)₂ est chauffé à 170°C (température d'évaporation), puis un flux d'azote de 200 sccm est introduit pour transporter la vapeur de Co(acac) sur les particules de diatomées mises en suspension (fluidisation) pendant 10 minutes. Ensuite, l'étape de réduction est réalisée en introduisant de l'hydrogène dilué à 20% dans de l'azote à 600°C pendant 20 minutes. Ensuite, l'acétylène, dilué lui aussi à 20% dans de l'azote, est introduit pendant 40 minutes.

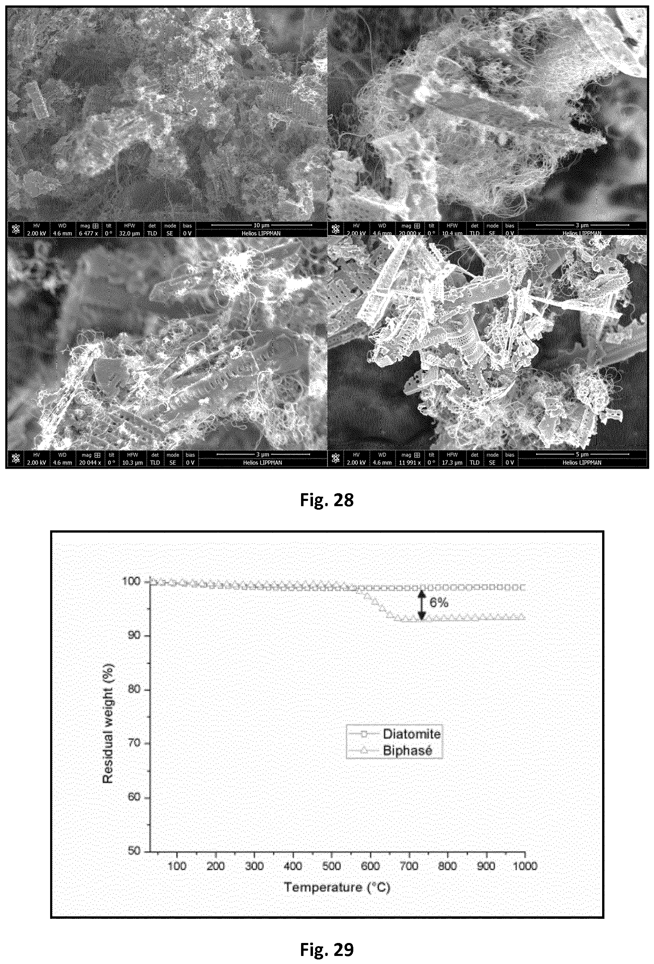

La figure 28 montre des images MEB de CNTs synthétisés sur des diatomées avec les paramètres sélectionnés précédemment. Une forte densité de CNTs sur certaines diatomées et une faible densité sur d'autres est remarquée. Le taux de couverture n'est pas égal à 100%. Certaines diatomées n'étaient peut-être pas suffisamment exposées aux gaz précurseurs.

La figure 29 montre l'analyse thermogravimétrique de l'échantillon présenté à la figure 28. La perte de masse a été mesurée dans un appareil NETZSCH-STA 409 PC, avec un flux d'air de 100 cm³.min⁻¹ dans un creuset en aluminium contenant 20-25 mg de l'échantillon. Les mesures ont été faites dans des conditions dynamiques avec une rampe de température de 10°C.min⁻¹.

A partir de 550°C, les nanotubes (et probablement le dépôt de résidus de carbone) sont complètement oxydés, ce qui permet d'approximer le taux de couverture à 6% en masse par rapport aux diatomées.

Les matériaux biphasiques à base de silice (diatomées) et de nanotubes de carbones conforme à la présente invention sont notamment utilisés comme agent de renforcement dans des matériaux composites à base de polymères, plus particulièrement à base d'élastomères.

Ces agents de renforcement présentent des propriétés remarquables, dont notamment l'augmentation de la surface spécifique de matériau à base de silice dû à l'introduction de nanotube de carbone, l'apport de propriétés électriques et/ou thermiques aux matériaux à base de silice.

Deux polymères distincts ont été utilisés, afin d'intégrer les matériaux biphasique à base de silice et de nanotubes de carbones. Les deux polymères sont d'abord le polyméthacrylate de méthyle (« PMMA » en anglais) en tant que matrice modèle utilisée dans la littérature (Mathur R. B., et al., Polym. Compos., 2008, 29, 717-727). Compte-tenu de la littérature abondante sur les composites PMMA-nanotubes de carbone, le PMMA est un bon matériau de référence pour évaluer l'apport des charges biphasiques dans l'amélioration des propriétés mécaniques, thermiques et électriques du PMMA.

Ensuite, l'utilisation d'un élastomère de type styrène-butadiène (SBR, de l'anglais « Styrene Butadiene Rubber »), proche de ce que l'industrie pneumatique utilise dans leur formulation.

### Nanocomposites à base de PMMA et de charges biphasées.

Les propriétés mécaniques et thermiques du composite à base de PMMA et de biphasés sont étudiées. Les mélanges ont été faits à la température de 180°C (suffisante pour faire fondre le PMMA) et à une vitesse de rotation de 10 rpm, pour éviter de détacher les tubes des diatomées.

### Stabilité thermique

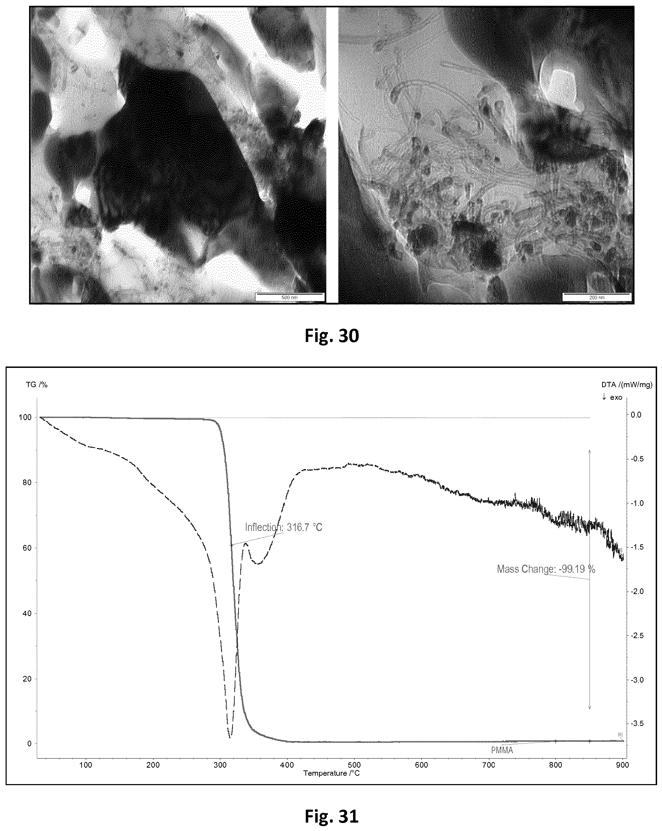

La figure 30 montre les images MET de composite de PMMA chargés à 10% en masse de biphasés obtenu à 10 rpm de vitesse de rotation des vis de l'extrudeuse. Les nanotubes forment un réseau continu et unifome autour des cœurs de diatomées. Néanmoins, la vitesse 10 rpm semble suffisamment importante pour « arracher » quelques nanotubes isolées des diatomées. Les charges biphasées diatomées/CNTs sont dispersées de manière homogène dans la matrice PMMA, avec une forte concentration de nanotubes autour des cœurs de diatomées.

La dégradation thermique sous atmosphère inerte du PMMA a largement été étudiée dans la littérature. Une dégradation thermique du pur PMMA vers 310°C est observée en accord avec les données reportées dans la littérature (290°C-315°C) (Costache M.C., et al., Polym. Adv. Technol., 2006, 17, 272-280).

La figure 31 indique également la DTA (analyse thermodifférentielle) du PMMA, avec un comportement endothermique de la décomposition thermique du PMMA dans une atmosphère inerte. Ce comportement est associé à la dépolymérisation de la chaine principale par la rupture aléatoire de liaisons C-C et la formation de volatiles monomères methyl methacrylate.

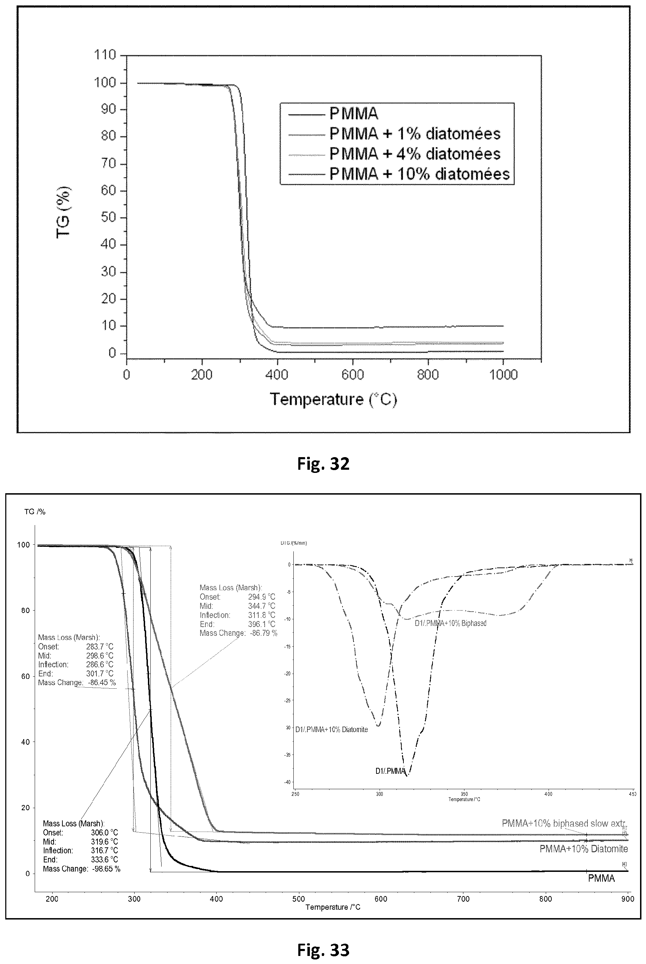

En ajoutant des diatomées pures (sans CNTs greffés) dans le PMMA, la dégradation intervient à plus basse température, autour de 280°C (Figure 32).

Il a été montré que l'interaction entre les macroradicaux (R) et l'oxygène est la réaction exothermique la plus probable pour la déstabilisation du PMMA (Troitskii B. B., Inhibition of thermo-oxidative degradation of PMMA and polystyrene by C 60, 2000, 36, 1073-1084). Les radicaux RO₂ générés réagissent avec les macromolécules pour la formation de polymères hydroperoxides polymériques. Celle-ci mène à la formation de radicaux libres qui initient la dégradation du PMMA. La présence d'oxygène tend à catalyser la dépolymérisation du PMMA par rapport à une décomposition purement thermique.

En présence de charges biphasées diatomées/nanotubes de carbone, la température de dégradation thermique est fortement augmentée, d'environ +25°C (figure 33). La présence de nanotubes de carbone augmente significativement la stabilité thermique du PMMA même en présence de cœur de diatomées qui a tendance à déstabiliser cette matrice polymérique. L'effet stabilisant des nanotubes dans les polymères est bien connu (Pande S., et al., Polym. Compos., 2009, 30, 1312-1317) et pourrait être attribué au fait qu'ils interagissent avec les macroradicaux pour former des composés moins actifs.

En s'intéressant à la dérivée de la TGA, deux mécanismes de dégradations sont remarqués : un premier qui intervient vers 310°C et qui est proche de la température caractéristique de dépolymérisation du PMMA catalysé par les diatomées seules; un autre qui intervient autour de 375°C et qui est attribué à la neutralisation des radicaux libres se liant avec les nanotubes de carbone (piégeage de surface).

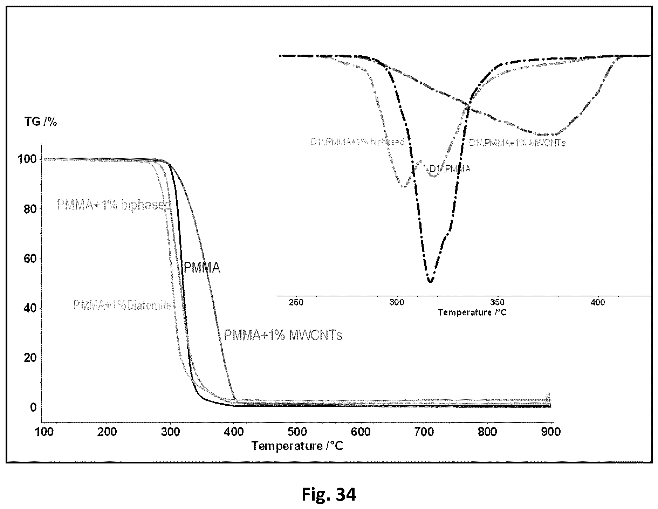

Cet effet stabilisant des nanotubes a été confirmé en mélangeant seulement des nanotubes de carbone multi-parois et du PMMA (figure 34) selon les mêmes conditions de mélange. Dans ce cas, un seul mécanisme de dégradation intervenant autour de 375°C est identifié et attribué aux mécanismes de neutralisation des radicaux par les nanotubes multi-parois. A 1% de charges biphasées, une légère stabilisation par rapport aux diatomées est observée. Dès lors, à cette concentration massique en charges biphasées, l'effet des nanotubes ne suffit pas pour compenser l'effet des diatomées et augmenter la stabilité du composite par rapport au PMMA.

Les diatomées ont un effet catalytique accélérant la dégradation thermique du composite et réduisant sa stabilité thermique par rapport au PMMA seul. Les nanotubes ont l'effet inverse, ils ont tendance à augmenter la stabilité thermique du composite et peuvent même compenser l'effet des diatomées à 10% de renforcement lors de l'utilisation des charges biphasées. A faibles taux de renforcement, l'effet des diatomées l'emporte cependant sur les nanotubes (figure 34).

### Propriétés mécaniques

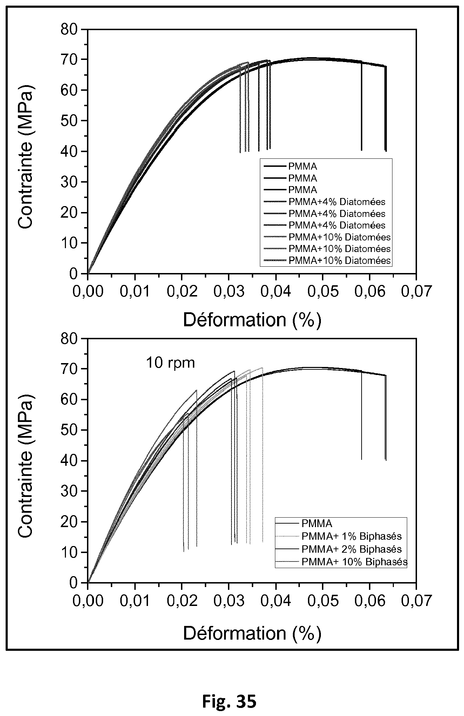

Les propriétés mécaniques des composites de PMMA renforcé par des diatomées et des charges biphasées à 10 rpm de vitesse de rotation sont présentées à la figure 35. Pour chaque matériau nanocomposite, les trois éprouvettes reproductibles en termes de quantité de matière ou de géométrie ont été mesurées.

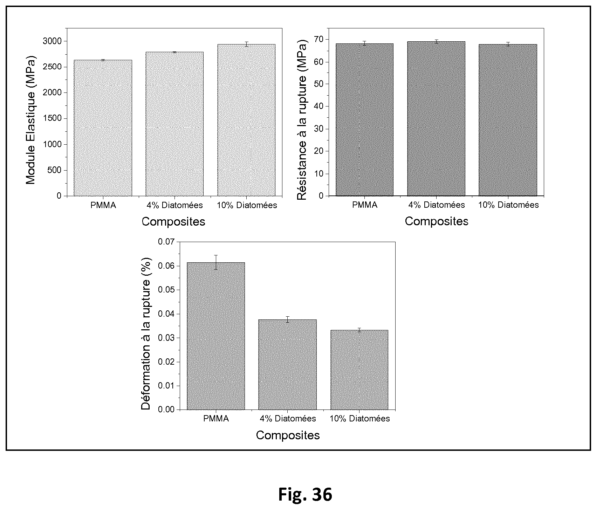

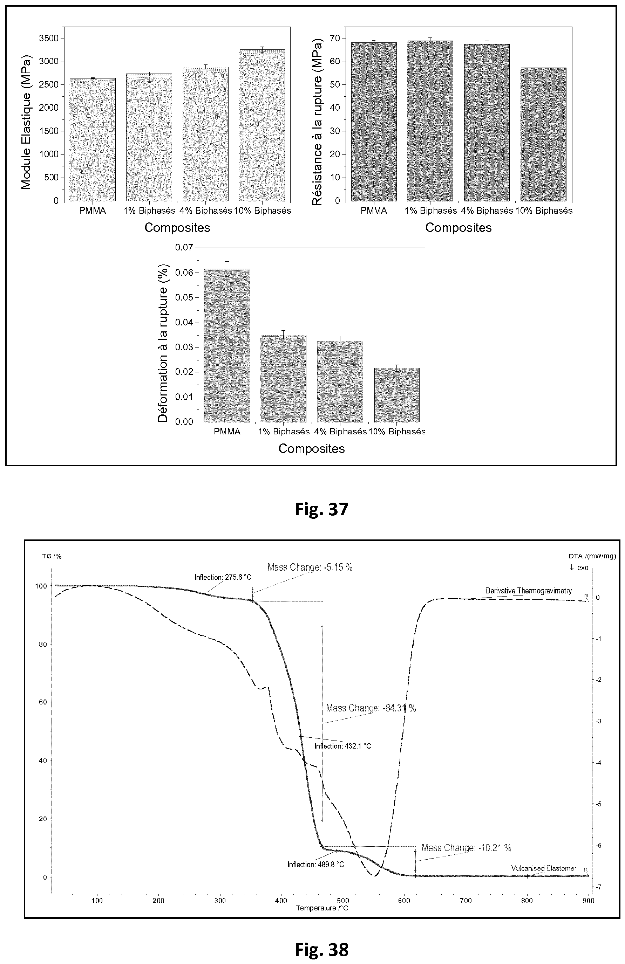

Ces courbes montrent l'évolution de la déformation du matériau sous l'effet des sollicitations mécaniques. Pour tous ces matériaux, la contrainte à la rupture est très similaire alors que la déformation plastique est nettement réduite lorsque des charges de renfort sont intégrées à la matrice PMMA. Trois paramètres sont extraits à partir de ces courbes : le module de Young qui caractérise la rigidité du matériau, la résistance à la rupture qui est la contrainte maximale atteinte durant l'essai de traction (appelée aussi résistance à la traction ou Rm) et enfin la déformation à la rupture ou l'allongement du matériau à la rupture. Ces trois paramètres sont pertinents pour bien exprimer les propriétés mécaniques des nanocomposites à base de PMMA renforcé par des diatomées et des charges biphasées (diatomée + nanotubes de carbone). Leur variation en fonction des concentrations de diatomées et de charges biphasées est présentée dans les figures 36 et 37.

Le module élastique (figure 36) passe de 2639 (+/-13) MPa pour le PMMA à 2793 (+/-10) en ajoutant 4% de diatomées au PMMA, soit une augmentation de 6%. A 10% de diatomées, on observe une augmentation de 11% de plus. La résistance à la traction Rm ne change pas par rapport à celle du PMMA à 4% et à 10%. La diminution de l'élongation est observée et passe de 0,06 (+/-0,003) pour le PMMA à 0,037 (+/-0.001) à 4% de diatomées et 0,033 (+/-0.001) à 10% de diatomées.

Globalement, l'ajout de diatomées dans le PMMA augmente le module de Young du composite (qui augmente avec la concentration de diatomées). Cette augmentation peut aller jusqu'à 24% par rapport au PMMA. La résistance à la rupture ne change pas même en augmentant la concentration de charges. Par ailleurs, l'allongement à la rupture diminue avec l'augmentation de la quantité de diatomées (figure 36). Cette diminution de l'élongation avec l'augmentation de la concentration de diatomées est logique. L'interface entre la matrice et l'inclusion est une zone de concentration de contrainte provoquant des points de rupture.

A faible concentration de charges biphasées, il y a une augmentation du module de Young, aucun changement de la valeur de Rm et une diminution de l'élongation. C'est à partir de 10% que la valeur de Rm diminue remarquablement (-16%), ce qui signifie une détérioration des propriétés mécaniques du composite. Cet effet qui visiblement provient des CNTs est dû à leur mauvaise dispersion dans le PMMA. En effet les CNTs ont tendance à s'organiser en réseaux autour des diatomées, à concentration plus élevée, on assiste à une augmentation des contraintes résiduelles aux interfaces charges-matrice provoquant ainsi à une diminution de la résistance du composite.

### Nanocomposites à base de SBR et de charges biphasées (diatomées + nanotubes de carbones).

La fabrication de nanocomposites à base de SBR renforcé aux fibres de verre et de charges biphasées est décrite. La température de mélange a été fixée à 90°C, la vitesse de rotation à 10 rpm. Des agents de vulcanisation tels que le cyclohexyle-benzothiazyle sulphonamide (CBS), du dibenzyle-dithiocarbamate de zinc (ZBec) qui permettent d'accélérer la vulcanisation, et l'agent de vulcanisation principal, le soufre (S) ont été ensuite rajoutés.

Les dimensions des éprouvettes sont : 65 mm x 10 mm x 3 mm.

### Stabilité thermique.

La dégradation thermique sous atmosphère inerte de l'élastomère seul est présentée à la figure 38. Trois points d'inflexion sur la courbe sont observés. Autour de 275°C, il y a une perte de masse de 5%, due aux pertes des huiles plastifiantes qui se produit à cette température relativement basse. Autour de 430°C, la perte de masse de 84% est due à la dégradation du caoutchouc naturel. Sur la courbe DTA, un pic vers 380°C (∼40% de masse) et un pic à 480°C (∼ 30% de masse) sont observés, ce qui permet de conclure que la dégradation du caoutchouc naturel se fait donc en deux étapes. Enfin à 490°C, les 10% de perte de masse devraient correspondre aux charges inorganiques.

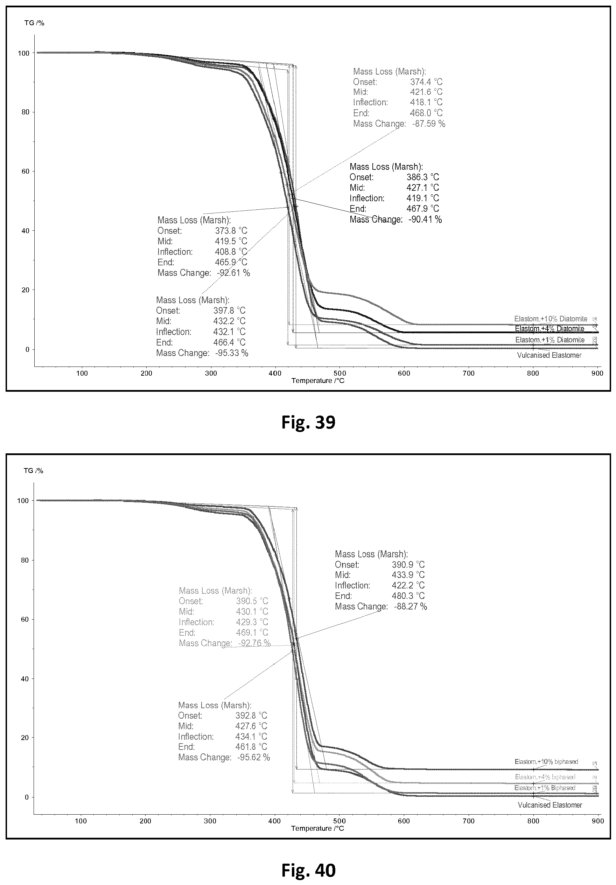

L'ajout de diatomées dans le SBR diminue légèrement la stabilité thermique de l'élastomère comme le montre la figure 39. En considérant la température aux points d'inflexion, 1% de diatomées provoque un décalage de -24°C ; à 4%, le décalage est de - 13°C et de -14°C à 10% de diatomées.

L'ajout de charges biphasées dans le SBR n'affecte pas la stabilité du composite (figure 40). A 1% de charges, le décalage est de +2°C. Par contre à 4 et 10% la diminution est de -3°C et -10°C respectivement. Par rapport au SBR chargé de diatomées, les charges biphasées augmentent seulement légèrement la stabilité du matériau. L'effet stabilisant des CNTs n'a pas été suffisant pour compenser l'effet déstabilisant des diatomées dans l'élastomère.

### Propriétés mécaniques.

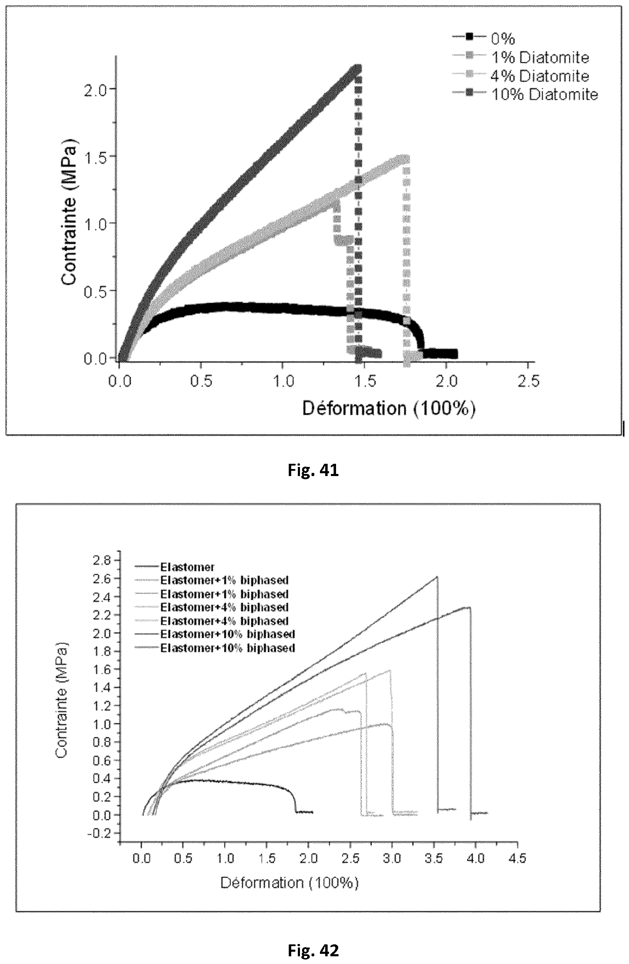

Les figures 41 et 42 montrent les courbes de contrainte-déformation obtenues après des tests de traction sur du SBR seul et du SBR renforcé à 1, 4 et 10% massique de diatomées et 1, 4 et 10% de biphasés (diatomées + nanotubes de carbone).

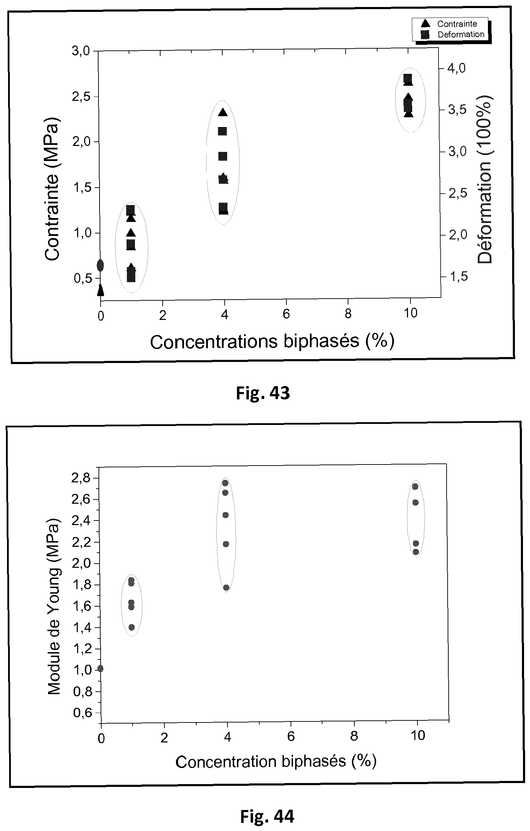

A partir de ces courbes, les valeurs du module de Young, de la résistance à la traction et de l'allongement ont été extraites (figures 43 et 44).

L'ajout (en quantité croissante) de diatomées augmente significativement le module de Young et la résistance à la traction du SBR mais diminue l'élongation par rapport au SBR. Les diatomées forment un bon interfaçage avec les molécules du SBR.

L'ajout de biphasés augmente énormément le module de Young, la résistance à la rupture et même l'élongation du matériau. Dans tous les cas, il y a une certaine variabilité pour une concentration donnée liée à l'hétérogénéité des échantillons. A 1% de biphasés, un module de Young qui augmente entre 50 à 100%, une résistance qui augmente de 100 à 350% et une élongation qui augmente de 10 à 42% ont été observés. A 4%, le module de Young connait une augmentation entre 170 et 270%, la résistance, de 350 à 650% et l'élongation de 250 à 350%. A 10% de biphasés, une augmentation entre 200 et 270% pour le module de Young, entre 500 et 700% pour la résistance et entre 350 et 400% d'élongation ont été observés.

L'apport des CNTs sur les performances mécaniques est donc remarquable, ils ont augmenté entre 6 et 11% la résistance à la traction par rapport au composite SBR-diatomées. Quant à l'élongation, elle passe de 150 % pour 10% de diatomées à 400% à 10% de biphasés. Les CNTs améliorent nettement l'interfaçage entre les diatomées et la matrice.

### Propriétés électriques.

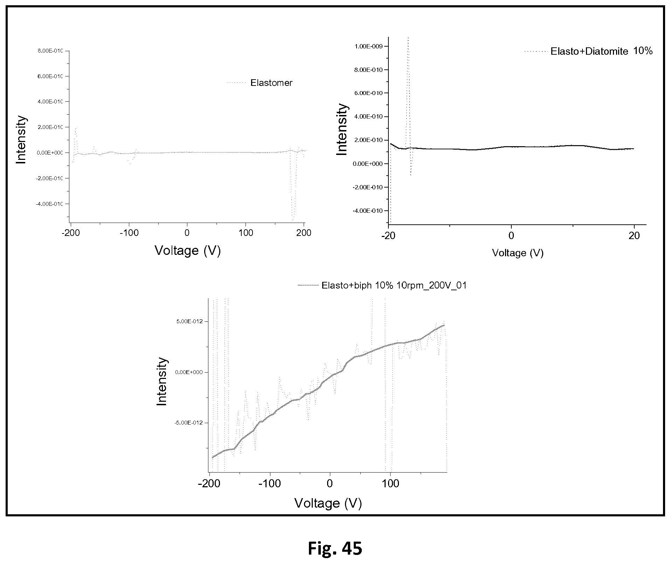

Des mesures électriques (figure 45) sur trois échantillons ont été réalisées: du SBR, du SBR chargé de 10% de de diatomées et du SBR chargé de 10% de biphasés en appliquant une tension de 200V avec un dispositif de deux pointes. Seul le troisième est conducteur avec une conductivité de 2.5 10⁻¹⁴ S à 10% de charges biphasées. Cette valeur de conductivité qui correspond à 0.6% massique de CNTs dans le composite est intéressante. Elle pourrait permettre d'atteindre des taux de percolation avec de faibles concentrations de CNTs en optimisant le procédé de croissance de CNTs.

## Revendications

1. Matériau composite
comprenant au moins une matrice de polymère,
ladite matrice de polymère comprenant au moins une charge inorganique composée d'un matériau biphasé,
ledit matériau biphasé comprenant au moins un substrat mésoporeux au moins partiellement recouvert de nanotubes de carbone,
**caractérisé en ce que**
ledit substrat mésoporeux est un substrat mésoporeux de porosité non-organisée qui comprend de la silice de diatomées.

2. Matériau composite selon la revendication 1, **caractérisé en ce que** ledit substrat mésoporeux de porosité non-organisée comprend de la diatomite.

3. Matériau composite selon l'une quelconque des revendications 1-2, **caractérisé en ce que** la composition dudit substrat mésoporeux de porosité non-organisée dans ledit matériau composite est comprise entre 1% et 30%, préférentiellement entre 1% et 10%.

4. Matériau composite selon l'une quelconque des revendications 1-3, **caractérisé en ce que** la composition dudit substrat mésoporeux de porosité non-organisée dans ledit matériau composite est de 1%, 2%, 3%, 4%, 5%, 6%, 7%, 8%, 9% ou 10%, préférentiellement de 1%, 4% ou 10%.

5. Matériau composite selon l'une quelconque des revendications 1 à 4, **caractérisé en ce que** ladite matrice de polymère est composée de poly (méthacrylate de méthyle) et/ou d'au moins un élastomère, ledit élastomère étant de préférence le caoutchouc de butadiène styrène.

6. Matériau composite selon la revendication 5, **caractérisé en ce que** la température de dégradation thermique dudit matériau composite avec une matrice de polymère composée de poly(méthacrylate de méthyle) augmente de 25°C par rapport à la température de dégradation thermique du poly(méthacrylate de méthyle).

7. Matériau composite selon la revendication 5, **caractérisé en ce que** le module de Young dudit matériau composite avec une matrice de polymère composée de caoutchouc de butadiène styrène augmente entre 50% et 300% par rapport au module de Young du caoutchouc de butadiène styrène.

8. Matériau composite selon la revendication 5, **caractérisé en ce que** la conductivité électrique dudit matériau composite avec une matrice de polymère composée de caoutchouc de butadiène styrène et une composition de diatomée de 10% est de 2.5 10⁻¹⁴ S.cm⁻¹.

9. Procédé de synthèse d'un matériau composite, ledit procédé de synthèse comprenant une étape d'extrusion entre au moins une matrice de polymère et au moins un matériau biphasé, **caractérisé en ce que** ledit matériau composite est en accord avec l'une quelconque des revendications 1 à 8.

10. Procédé de synthèse selon la revendication 9, ledit matériau biphasé étant synthétisé en deux étapes :
a. une étape de provision d'un catalyseur sur au moins un substrat mésoporeux, ledit catalyseur étant un dérivé de nickel ou un dérivé de cobalt, et
b. une étape de croissance des nanotubes de carbone,
**caractérisé en ce que**
les deux étapes (a) et (b) sont effectuées en une synthèse monotope.

11. Procédé de synthèse selon la revendication 10, caractérisé en ce l'étape (a) est effectuée par imprégnation du catalyseur en phase vapeur, par dépôt chimique en phase vapeur ou par dépôt de couches atomiques, de préférence par imprégnation du catalyseur en phase vapeur.

12. Procédé selon l'une quelconque des revendications 10-11, **caractérisé en ce que** ledit catalyseur est une nanoparticule métallique fournie dans une phase gazeuse.

13. Procédé selon l'une quelconque des revendications 10 à 12, **caractérisé en ce que** ledit catalyseur est du Ni(acac)₂, ou du Co(acac)₂.

14. Procédé selon l'une quelconque des revendications 10 à 13, **caractérisé en ce que** ledit catalyseur est réduit par un dérivé d'alcool ou par de l'hydrogène gazeux.

15. Procédé selon la revendication 14, **caractérisé en ce que** ledit dérivé d'alcool est un alcool primaire, de préférence le méthanol, l'éthanol et/ou propanol.

16. Procédé selon l'une quelconque des revendications 14-15, **caractérisé en ce que** ledit catalyseur et ledit dérivé d'alcool sont appliqués simultanément lorsque ladite étape de provision d'un catalyseur sur ledit au moins un substrat mésoporeux est réalisée par dépôt chimique en phase vapeur.

17. Procédé selon l'une quelconque des revendications 14-15, **caractérisé en ce que** ledit dérivé d'alcool est appliqué une fois que ledit au moins un catalyseur est déposé sur ledit au moins un substrat mésoporeux lorsque ladite étape de provision d'un catalyseur sur ladite au moins un substrat mésoporeux est réalisée par dépôt de couche atomique.

18. Procédé selon la revendication 14, **caractérisé en ce que** ledit hydrogène gazeux est mélangé avec de l'azote gazeux ou un autre gaz inerte.

19. Procédé selon la revendication 18, **caractérisé en ce que** ledit mélange entre ledit hydrogène gazeux et ledit azote gazeux comprend une portion d'hydrogène gazeux qui est comprise entre 2% et 30%, préférentiellement entre 10% et 20%.

20. Procédé selon l'une quelconque des revendications 14, 18 ou 19, **caractérisé en ce que** l'étape de réduction du catalyseur par l'hydrogène gazeux est effectuée pendant une durée comprise entre 2 minutes et 30 minutes, de préférence entre 5 minutes et 20 minutes, plus préférentiellement entre 10 minutes et 20 minutes, encore plus préférentiellement pendant une durée de 20 minutes.

21. Procédé selon l'une quelconque des revendications 9 à 20, **caractérisé en ce que** ledit au moins substrat mésoporeux est composé d'un substrat mésoporeux de porosité non-organisée qui comprend de la silice de diatomées, encore plus préférentiellement de diatomites.

22. Procédé selon la revendication 21, **caractérisé en ce que** ledit au moins un dérivé de la silice de porosité non-organisée est thermiquement oxydé à 1100°C pour fournir une couche de dioxyde de silicium de 50 nm d'épaisseur, avant ladite étape de provision d'un catalyseur sur ledit au moins un substrat mésoporeux.

23. Procédé selon l'une quelconque des revendications 13-22, **caractérisé en ce que** le Ni(acac)₂ est sublimé à une température comprise entre 150°C et 190°C, préférentiellement à 180°C.

24. Procédé selon l'une quelconque des revendications 13-22, **caractérisé en ce que** le Co(acac)₂ est sublimé à une température comprise entre 150°C et 190°C, préférentiellement à 170°C.

25. Procédé selon l'une quelconque des revendications 10 à 24, **caractérisé en ce que** ladite synthèse monotope est effectuée dans un réacteur à lit fluidisé.

26. Procédé selon l'une quelconque des revendications 10 à 25, **caractérisé en ce que** ladite étape de croissance de nanotubes de carbone comprend une étape de croissance avec de l'acétylène gazeux, ledit acétylène gazeux étant mélangé avec de l'azote gazeux ou un autre gaz inerte.

27. Procédé selon l'une quelconque des revendications 10 à 26, **caractérisé en ce que** ladite étape de croissance des nanotubes de carbone est effectuée à une pression comprise entre 2 mbar et 15 mbar, préférentiellement à 13 mbar, et à une température comprise entre 500°C et 800°C, de préférence à une température de 500°C, 550°C, 600°C, 700°C ou 800°C, plus préférentiellement à une température de 600°C.

28. Procédé selon l'une quelconque des revendications 10 à 27, **caractérisé en ce que** ladite étape de croissance des nanotubes est effectuée pendant une durée comprise entre 3 minutes et 60 minutes, de préférence pendant un temps de 20 minutes, 40 minutes ou 60 minutes, plus préférentiellement pendant un temps de 40 minutes ou 60 minutes, encore plus préférentiellement pendant une période de 40 minutes.

29. Procédé selon l'une quelconque des revendications 26 à 28, **caractérisé en ce que** ledit mélange entre l'acétylène gazeux et ledit azote gazeux comprend une portion d'acétylène gazeux par rapport à l'azote gazeux qui est comprise entre 2% et 30%, de préférence qui est de 10% ou 20%, plus préférentiellement qui est de 20%.

## Patentansprüche

1. Verbundmaterial
umfassend mindestens eine Polymermatrix,
wobei die Polymermatrix mindestens einen anorganischen Füllstoff umfasst, der aus einem zweiphasigen Material besteht,
wobei das zweiphasige Material mindestens ein mesoporöses Substrat umfasst, das mindestens teilweise mit Kohlenstoffnanoröhren bedeckt ist,
**dadurch gekennzeichnet, dass**
das mesoporöse Substrat ein mesoporöses, eine nicht organisierte Porosität aufweisendes, und Kieselsäure von Diatomeen umfassendes Substrat ist.

2. Verbundmaterial nach Anspruch 1, **dadurch gekennzeichnet, dass** das mit nicht organisierter Porosität mesoporöse Substrat Kieselgur umfasst.

3. Verbundmaterial nach einem der Ansprüche 1 bis 2, **dadurch gekennzeichnet, dass** die Zusammensetzung des mit nicht organisierter Porosität mesoporösen Substrats in dem Verbundmaterial zwischen 1 % und 30 % liegt, vorzugsweise zwischen 1 % und 10 %.

4. Verbundmaterial nach einem der Ansprüche 1 bis 3, **dadurch gekennzeichnet, dass** die Zusammensetzung des mit nicht organisierter Porosität mesoporösen Parasitensubstrats in dem Verbundmaterial zwischen 1 %, 2 %, 3 %, 4 %, 5 %, 6%, 7 %, 8 %, 9 % oder 10 % liegt, vorzugsweise zwischen 1 %m 4 % oder 10 %.

5. Verbundmaterial nach einem der Ansprüche 1 bis4, **dadurch gekennzeichnet, dass** die Polymermatrix aus Poly(methylmethacrylat) und / oder mindestens einem Elastomer, wobei das Elastomer vorzugsweise Styrol-Butadien-Kautschuk zusammengesetzt ist.

6. Verbundmaterial nach Anspruch 5, **dadurch gekennzeichnet, dass** die thermische Zersetzungstemperatur des Verbundmaterials mit einer Polymermatrix aus Poly(methylmethacrylat) gegenüber der thermischen Zersetzungstemperatur von Poly(methylmethacrylat) um 25 ° C ansteigt.

7. Verbundmaterial nach Anspruch 5, **dadurch gekennzeichnet, dass** das Elastizitätsmodul des Verbundmaterials mit einer Polymermatrix aus Styrol-Butadien-Kautschuk zwischen 50 % und 300 % gegenüber dem Elastizitätsmodul von Styrol-Butadien-Kautschuk zunimmt.

8. Verbundmaterial nach Anspruch 5, **dadurch gekennzeichnet, dass** die elektrische Leitfähigkeit des Verbundmaterials mit einer Polymermatrix aus Styrol-Butadien-Kautschuk und einer 10%igen Zusammensetzung aus Diatomeen 2,5 10⁻¹⁴ S.cm⁻¹ beträgt.

9. Verfahren zur Synthese eines Verbundmaterials, wobei das Syntheseverfahren einen Extrusionsschritt zwischen mindestens einer Polymermatrix und mindestens einem Zweiphasenmaterial umfasst, **dadurch gekennzeichnet, dass** das Verbundmaterial einem der Ansprüche 1 bis 8 entspricht.

10. Syntheseverfahren nach Anspruch 9, wobei das zweiphasige Material in zwei Schritten synthetisiert wird:
a. Schritt zum Bereitstellen eines Katalysators auf einem mesoporösen Substrat, wobei der Katalysator ein Nickelderivat oder ein Kobaltderivat ist, und
b. Kohlenstoffnanoröhren-Wachstumsschritt,
**dadurch gekennzeichnet, dass** die beiden Schritte (a) und (b) in einer Eintopfsynthese durchgeführt werden.

11. Syntheseverfahren nach Anspruch 10, **dadurch gekennzeichnet, dass** der Schritt (a) durch Imprägnieren des Katalysators in der Dampfphase, durch chemische Abscheidung in der Dampfphase oder durch Abscheidung von Atomschichten, vorzugsweise durch Imprägnieren des Katalysators in der Dampfphase durchgeführt wird.

12. Verfahren nach einem der Ansprüche 10 bis 11, **dadurch gekennzeichnet, dass** der Katalysator ein metallisches Nanopartikel ist, das in einer Gasphase bereitgestellt wird.

13. Verfahren nach einem der Ansprüche 10 bis 12, **dadurch gekennzeichnet, dass** der Katalysator Ni(acac) 2 oder Co(acac)₂ ist.

14. Verfahren nach einem der Ansprüche 10 bis 13, **dadurch gekennzeichnet, dass** der Katalysator durch ein Alkoholderivat oder durch Wasserstoffgas reduziert wird.

15. Verfahren nach Anspruch 14, **dadurch gekennzeichnet, dass** das Alkoholderivat ein primärer Alkohol, vorzugsweise Methanol, Ethanol und / oder Propanol ist.

16. Verfahren nach einem der Ansprüche 14 bis 15, **dadurch gekennzeichnet, dass** Katalysator und Alkoholderivat gleichzeitig angewendet werden, wenn der Schritt der Zufuhr eines Katalysators zu dem mindestens einen mesoporösen Substrat durch chemische Gasphasenabscheidung durchgeführt wird.

17. Verfahren nach einem der Ansprüche 14 bis 15, **dadurch gekennzeichnet, dass** der Alkohol einmal aufgebracht wird, nachdem der mindestens eine Katalysator auf dem mindestens einen mesoporösen Substrat abgeschieden wurde, wenn der Schritt der Bereitstellung eines Katalysators auf dem mindestens einen mesoporösen Substrat durch Atomlagenabscheidung durchgeführt wird.

18. Verfahren nach Anspruch 14, **dadurch gekennzeichnet, dass** das Wasserstoffgas mit Stickstoffgas oder einem anderen Inertgas gemischt wird.

19. Verfahren nach Anspruch 18, **dadurch gekennzeichnet, dass** das Gemisch zwischen dem gasförmigen Wasserstoff und dem gasförmigen Stickstoff einen Teil des gasförmigen Wasserstoffs umfasst, der zwischen 2 % und 30 %, vorzugsweise zwischen 10 % und 20 % liegt.

20. Verfahren nach einem der Ansprüche 14, 18 oder 19, **dadurch gekennzeichnet, dass** der Schritt der Reduktion des Katalysators mit gasförmigem Wasserstoff in einem Zeitraum zwischen 2 Minuten und 30 Minuten, vorzugsweise zwischen 5 Minuten und 20 Minuten, bevorzugter zwischen 10 Minuten und 20 Minuten, noch bevorzugter in einem Zeitraum von 20 Minuten durchgeführt wird.

21. Verfahren nach einem der Ansprüche 9 bis 20, **dadurch gekennzeichnet, dass** das mindestens mesoporöse Substrat aus einem mit nicht organisierter Porosität mesoporösen Substrat, der Kieselsäure von Diatomeen, noch bevorzugter von Kieselgur umfasst.

22. Verfahren nach Anspruch 21, **dadurch gekennzeichnet, dass** das mindestens ein Derivat von mit nicht organisierter Porosität Kieselsäure bei 1100 °C thermisch oxidiert wird, um eine 50 nm dicke Schicht aus Siliciumdioxid bereitzustellen, bevor der Schritt des Bereitstellens eines Katalysators auf dem mindestens einen mesoporösen Substrat erfolgt.

23. Verfahren nach einem der Ansprüche 13 bis 22, **dadurch gekennzeichnet, dass** Ni(acac)₂ bei einer Temperatur zwischen 150 °C und 190 °C, vorzugsweise bei 180 °C, sublimiert wird.

24. Verfahren nach einem der Ansprüche 13 bis 22, **dadurch gekennzeichnet, dass** Co(acac)₂ bei einer Temperatur zwischen 150 °C und 190 °C, vorzugsweise bei 170 °C, sublimiert wird.

25. Verfahren nach einem der Ansprüche 10 bis 24, **dadurch gekennzeichnet, dass** die Eintopfsynthese in einem Fließbettreaktor durchgeführt wird.

26. Verfahren nach einem der Ansprüche 10 bis 25, **dadurch gekennzeichnet, dass** der Schritt des Wachstums von Kohlenstoffnanoröhren einen Schritt des Wachstums mit gasförmigem Acetylen umfasst, wobei das gasförmige Acetylen mit Stickstoffgas oder einem anderen Inertgas gemischt wird.

27. Verfahren nach einem der Ansprüche 10 bis 26, **dadurch gekennzeichnet, dass** der Schritt des Wachstums von Kohlenstoffnanoröhren bei einem Druck zwischen 2 mbar und 15 mbar, vorzugsweise bei 13 mbar, und bei einer Temperatur zwischen 500 °C und 800 °C, vorzugsweise bei einer Temperatur von 500 °C, 550 °C, 600 °C, 700 °C oder 800 °C, bevorzugter bei einer Temperatur von 600 °C durchgeführt wird.

28. Verfahren nach einem der Ansprüche 10 bis 27, **dadurch gekennzeichnet, dass** der Schritt des Wachstums von Kohlenstoffnanoröhren in einem Zeitraum zwischen 3 Minuten und 60 Minuten durchgeführt wird, vorzugsweise in einem Zeitraum von 20 Minuten, 40 Minuten oder 60 Minuten, bevorzugter in einem Zeitraum von 40 Minuten oder 60 Minuten, noch bevorzugter in einem Zeitraum von 40 Minuten.

29. Verfahren nach einem der Ansprüche 10 bis 28, **dadurch gekennzeichnet, dass** das Gemische Mischung zwischen gasförmigem Acetylen und gasförmigem Stickstoff einen Teil gasförmigen Acetylens relativ zu dem gasförmigen Stickstoff umfasst, der zwischen 2% und 30 % liegt, vorzugsweise 10 % oder 20 %, bevorzugter 20 %.

## Claims

1. Composite material
comprising at least one polymer matrix,
said polymer matrix comprising at least one inorganic load composed of a biphasic material, said biphasic material comprising at least one mesoporous substrate at least partially coated with carbon nanotubes.
**characterized in that**
said mesoporous substrate is a mesoporous substrate with non-organized porosity, comprising silica from diatoms.

2. Composite material according to Claim 1, **characterized in that** said mesoporous substrate with non-organized porosity comprises diatomite.

3. Composite material according to any one of Claims 1-2, **characterized in that** the composition of said mesoporous substrate with non-organized porosity in said composite material is comprised between 1% and 30%, preferably between 1% and 10%.

4. Composite material according to any one of Claims 1-3, **characterized in that** the composition of said mesoporous substrate with non-organized porosity in said composite material is 1%, 2%, 3%, 4%, 5%, 6%, 7%, 8%, 9% or 10%, preferably 1%, 4% or 10%.

5. Composite material according to any one of Claims 1 to 4, **characterized in that** said polymer matrix is composed of polymethylmethacrylate and/or at least one elastomer, said elastomer preferably being butadiene styrene rubber.

6. Composite material according to Claim 5, **characterized in that** the thermal degradation temperature of said composite material with a polymer matrix composed of polymethylmethacrylate increases by 25°C relative to the thermal degradation temperature of the polymethylmethacrylate.

7. Composite material according to Claim 5, **characterized in that** the Young's modulus of said composite material with a polymer matrix composed of butadiene styrene rubber increases between 50% and 300% relative to the Young's modulus of butadiene styrene rubber.

8. Composite material according to Claim 5, **characterized in that** the electrical conductivity of said composite material with a polymer matrix composed of butadiene styrene rubber and a composition of diatoms of 10% is 2.5 10⁻¹⁴ S.cm⁻¹.

9. Synthetic process for a composite material, said synthetic process comprising a step of extrusion between at least one polymer matrix and at least one biphasic material, **characterized in that** said composite material is in accord with any one of Claims 1 to 8.

10. Synthetic process according to Claim 9, said biphasic material being synthesized in two steps:
a. a step of providing a catalyst on at least one mesoporous substrate, said catalyst being configured to favour the growth of said carbon nanotubes, and
b. a step of growing the carbon nanotubes,
**characterized in that**
the two steps (a) and (b) are performed in a one-pot synthesis.

11. Synthetic process according to Claim 10, **characterized in that** step (a) is performed by vapour impregnation of the catalyst, by chemical vapour deposition or by atomic layer deposition, preferably by vapour impregnation of the catalyst.

12. Process according to any one of Claims 10-11, **characterized in that** said catalyst is a metal nanoparticle provided in a gas phase.

13. Process according to any one of Claims 10 to 12, **characterized in that** said catalyst is a nickel derivative, preferably Ni(acac)₂, or a cobalt derivative, preferably Co(acac)₂.

14. Process according to any one of Claims 10 to 13, **characterized in that** said catalyst is reduced by an alcohol derivative or by gaseous hydrogen.

15. Process according to Claim 14, **characterized in that** said alcohol derivative is a primary alcohol, preferably methanol, ethanol and/or propanol.

16. Process according to any one of Claims 14-15, **characterized in that** said catalyst and said alcohol derivative are applied simultaneously when said step of providing a catalyst on said at least one mesoporous substrate is performed by chemical vapour deposition.

17. Process according to any one of Claims 14-15, **characterized in that** said alcohol derivative is applied once said at least one catalyst is deposited on said at least one mesoporous substrate when said step of providing a catalyst on said at least one mesoporous substrate is performed by atomic layer deposition.

18. Process according to Claim 14, **characterized in that** said gaseous hydrogen is mixed with gaseous nitrogen or another inert gas.

19. Process according to Claim 18, **characterized in that** said mixture between said gaseous hydrogen and said gaseous nitrogen comprises a portion of gaseous hydrogen that is between 2% and 30%, preferably between 10% and 20%.

20. Process according to any one of Claims 14, 18 or 19, **characterized in that** the step of reducing the catalyst by gaseous hydrogen is performed during a period of between 2 minutes and 30 minutes, preferably between 5 minutes and 20 minutes, more preferably between 10 minutes and 20 minutes, even more preferably during a period of 20 minutes.

21. Process according to any one of Claims 9 to 20, **characterized in that** said at least one mesoporous substrate is composed of a mesoporous substrate with non-organized porosity comprising silica from diatoms, more preferably of diatomites.

22. Process according to Claim 21, **characterized in that** said at least one silica derivative with non-organized porosity is thermally oxidized at 1100°C to provide a layer of silicon dioxide 50 nm thick, before said step of providing a catalyst on said at least one mesoporous substrate.

23. Process according to any one of Claims 13-22, **characterized in that** the Ni(acac)₂ is sublimed at a temperature of between 150°C and 190°C, preferably at 180°C.

24. Process according to any one of Claims 13-22, **characterized in that** the Co(acac)₂ is sublimed at a temperature of between 150°C and 190°C, preferably at 170°C.

25. Process according to any one of Claims 10 to 24, **characterized in that** said one-pot synthesis is performed in a fluidized bed reactor.

26. Process according to any one of Claims 10 a 25, **characterized in that** said step of growing carbon nanotubes comprises a step of growth with gaseous acetylene, said gaseous acetylene being mixed with gaseous nitrogen or another inert gas.

27. Process according to any one of Claims 10 to 26, **characterized in that** said step of growing carbon nanotubes is performed at a pressure of between 2 mbar and 15 mbar, preferably at 13 mbar and at a temperature of between 500°C and 800°C, preferably at a temperature of 500°C, 550°C, 600°C, 700°C or 800°C, more preferably at a temperature of 600°C.

28. Process according to any one of Claims 10 to 27, **characterized in that** said step of growing nanotubes is performed during a period of between 3 minutes and 60 minutes, preferably for 20 minutes, 40 minutes or 60 minutes, more preferably for 40 minutes or 60 minutes, even more preferably for 40 minutes.

29. Process according to any one of Claims 26 to 28, **characterized in that** said mixture between gaseous acetylene and said gaseous nitrogen comprises a portion of gaseous acetylene relative to the gaseous nitrogen that is comprised between 2% and 30%, preferably that is 10% or 20%, more preferably that is 20%.
